(19) Europäisches Patentamt
European Patent Office
Office européen des brevets

(11) **EP 4 386 396 B1**

(12) **EUROPEAN PATENT SPECIFICATION**

(45) Date of publication and mention
of the grant of the patent:
**30.07.2025 Bulletin 2025/31**

(21) Application number: **21957779.8**

(22) Date of filing: **23.09.2021**

(51) International Patent Classification (IPC):
**G01R 31/28** (2006.01)  **G01R 31/3185** (2006.01)
**G01R 31/319** (2006.01)

(52) Cooperative Patent Classification (CPC):
**G01R 31/28; G01R 31/318572; G01R 31/31926**

(86) International application number:
**PCT/CN2021/119781**

(87) International publication number:
**WO 2023/044642 (30.03.2023 Gazette 2023/13)**

(54) **TEST CIRCUIT, INTEGRATED CIRCUIT, ELECTRONIC DEVICE, AND METHOD FOR GENERATING THE TEST CIRCUIT**

TESTSCHALTUNG, INTEGRIERTE SCHALTUNG, ELEKTRONISCHE VORRICHTUNG UND VERFAHREN ZUR ERZEUGUNG DER TESTSCHALTUNG

CIRCUIT D'ESSAI, CIRCUIT INTÉGRÉ, DISPOSITIF ÉLECTRONIQUE ET PROCÉDÉ DE GÉNÉRATION DU CIRCUIT D'ESSAI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.06.2024 Bulletin 2024/25**

(73) Proprietor: **Huawei Technologies Co., Ltd.**
**Shenzhen, Guangdong 518129 (CN)**

(72) Inventors:
• **CUI, Changming**
**Shenzhen, Guangdong 518129 (CN)**
• **FU, Haitao**
**Shenzhen, Guangdong 518129 (CN)**
• **ZHANG, Yu**
**Shenzhen, Guangdong 518129 (CN)**
• **DENG, Bin**
**Shenzhen, Guangdong 518129 (CN)**
• **HUANG, Junlin**
**Shenzhen, Guangdong 518129 (CN)**

(74) Representative: **Gill Jennings & Every LLP**
**The Broadgate Tower**
**20 Primrose Street**
**London EC2A 2ES (GB)**

(56) References cited:
CN-A- 105 357 070   CN-A- 107 345 997
CN-A- 107 345 997   CN-A- 112 612 264
US-A1- 2008 168 309   US-B1- 6 289 480

• ZONI DAVIDE ET AL: "Adaptive routing and Dynamic Frequency Scaling for NoC power-performance optimizations", 2013 23RD INTERNATIONAL WORKSHOP ON POWER AND TIMING MODELING, OPTIMIZATION AND SIMULATION (PATMOS), 1 September 2013 (2013-09-01), pages 231 - 234, XP093206137, Retrieved from the Internet <URL:https://re.public.polimi.it/retrieve/e0c31c10-0468-4599-e053-1705fe0aef77/PATMOS_06662179.pdf> [retrieved on 20240918], DOI: 10.1109/PATMOS.2013.6662179

**Description**

**TECHNICAL FIELD**

This application relates to the field of integrated circuit testing, and in particular, to a test circuit, an integrated circuit, an electronic device, and a method for generating a test circuit.

**BACKGROUND**

An integration scale of a system on chip (system on chip, SoC) is increasingly large, and one SoC chip may include hundreds or even thousands of cores (Cores), for example, a circuit module or an intellectual property (intellectual property, IP) module. Each core needs to be tested to ensure normal functions. Specifically, each core includes a test circuit and a tested circuit. The tested circuit generally includes a plurality of input channels (input channels) and a plurality of output channels (output channels). Test circuits of a plurality of cores are coupled through a shared test bus, and the test circuit outputs test excitation from the test bus to the input channel of the tested circuit and outputs a test response from the output channel of the tested circuit to the test bus. Finally, a test objective of the tested circuit is achieved by observing whether the test response meets an expectation.

The test excitation and test response of each core are transmitted through the shared test bus. A test circuit in a current core transparently transmits a test response from another core, or test excitation to be output to a tested circuit in another core. This takes a very short time. The test circuit spends a long time processing test excitation to be input to a tested circuit in the current core, or a test response generated by the tested circuit in the current core. When a transmission distance of the test bus is long, inconsistency in time causes inconsistency of timing of data transmission on each test bus. A transmission rate of the test bus has to be reduced to avoid a data transmission error. Document CN107345997 discloses converting scan output (SO) testing data after scan input (SI) testing data is obtained by an internal logic circuit of an IP core. Primary output (PO) testing data is obtained after primary input (PI) test data is passed through the circuit. The SO testing data is compared with an IP core testing pattern. Primary output (PO) testing data is compared with the IP core testing pattern. The SO testing data is output to an output port by scan chains. The PO testing data is obtained by a WBR unit for transmitting from the output port of the IP core to the output port of a testing shell.

**SUMMARY**

Embodiments of this application provide a test circuit, an integrated circuit, an electronic device, and a method for generating a test circuit, to implement consistency of timing of data transmission on a test bus and improve a transmission rate of the test bus.

To achieve the foregoing objectives, the following technical solutions are used in embodiments of this application.

According to a first aspect, a test circuit is provided, including: a first input bus, a second input bus, a first output bus, a second output bus, a first dynamic routing unit DRU, and a first register. The first input bus is configured to be coupled to an input channel of a tested circuit through the first DRU, and the first output bus is configured to be coupled to an output channel of the tested circuit through the first DRU. The second input bus is configured to be coupled to the second output bus through the first register. In a clock cycle: the first DRU is configured to output test excitation from the first input bus to the input channel of the tested circuit, and output a test response from the output channel of the tested circuit to the first output bus; or the first DRU is configured to output data from the first input bus to the first output bus; and the first register is configured to output data from the second input bus to the second output bus.

According to the foregoing test circuit provided in this embodiment of this application, a quantity of DRUs coupled to each first input bus is the same as a quantity of registers coupled to each second input bus, so that a delay of outputting test excitation to a tested circuit in a current core through a DRU and outputting a test response through the DRU, a delay of transparently transmitting data through the DRU, and a delay of transparently transmitting data through a register coupled to the second input bus in are the same. This implements consistency of timing of data transmission on the test bus, and improves a transmission rate of the test bus.

In a possible implementation, the test circuit further includes a second DRU, a second register, and a selection circuit. The first input bus is configured to be coupled to the input channel of the tested circuit through the first DRU, the second DRU, and the selection circuit, and the first output bus is configured to be coupled to the output channel of the tested circuit through the first DRU and the second DRU. The second input bus is configured to be coupled to the second output bus through the first register and the second register; and the selection circuit is configured to select the first DRU or the second DRU to be coupled to the input channel of the tested circuit. This application does not pose a limitation on one first input bus being coupled to one or two DRUs, and one second input bus is coupled to one or two registers. A quantity of DRUs coupled to the first input bus is the same as a quantity of registers coupled to the second input bus, so that each input bus has a same delay in transmitting data. When a transmission distance of the test bus is long, inconsistency of timing of data transmission on each input bus can be avoided. In this way, a transmission speed of the test bus is improved.

In a possible implementation, in a first clock cycle, the first DRU is configured to output the test excitation to the second DRU; and in a second clock cycle, the selection circuit selects the second DRU to be coupled to the input channel of the tested circuit, and the second DRU is configured to output the test excitation to the input channel of the tested circuit, and output the test response to the first output bus; or in a second clock cycle, the selection circuit selects the first DRU to be coupled to the input channel of the tested circuit, and the first DRU is configured to output the test excitation to the input channel of the tested circuit, and output the test response to the first output bus. In a conventional technology, because a quantity of pins (namely, bus bandwidths) of a chip for inputting test excitation and outputting test responses is limited, to make full use of the bus bandwidths, complete test excitation output to a core may be split into a plurality of parts and transmitted to the bus in a time-sharing manner. If these parts are input to an input channel of a tested circuit, an incorrect test response is generated. However, for the test circuit provided in this embodiment of this application, one test cycle may include two clock cycles. No matter in which clock cycle the test excitation is input, and no matter whether the test excitation is separately input in two clock cycles, the test excitation may be output to the input channel of the tested circuit in the second clock cycle, so that all parts of the test excitation that are input in a time-sharing manner are input to the input channel of the tested circuit at the same time, and this avoids generating an incorrect test response.

In a possible implementation, the selection circuit includes a first AND gate, a second AND gate, and a second selector, where a first input of the second AND gate performs phase inversion on an input signal. An output of the first AND gate is coupled to the first DRU to output a first signal to the first DRU, an output of the second AND gate is coupled to the second DRU to output a second signal to the second DRU, a first input of the first AND gate and the first input of the second AND gate are coupled to a control end of the second selector and are configured to input a third signal, a second input of the first AND gate and a second input of the second AND gate are coupled and are configured to input a fourth signal. Two inputs of the second selector are respectively coupled to the first DRU and the second DRU, and an output of the second selector is configured to be coupled to the input channel of the tested circuit. The first signal is used to control the first DRU whether to output the test excitation to the input channel of the tested circuit, the second signal is used to control the second DRU whether to output the test excitation to the input channel of the tested circuit, the third signal is used to control the selection circuit to select the first DRU or the second DRU to be coupled to the input channel of the tested circuit, and the fourth signal is used to control the first DRU or the second DRU whether to output the test excitation to the input channel of the tested circuit. This implementation provides a possible structure of the selection circuit.

In a possible implementation, the first DRU includes a third register and a third selector. A data input of the third register is configured to be coupled to the first input bus, a data output of the third register is configured to be separately coupled to a second input of the third selector and the input channel of the tested circuit, a first input of the third selector is configured to be coupled to the output channel of the tested circuit, an output of the third selector is configured to be coupled to the first output bus, a control end of the third selector is configured to input a fifth signal, and the fifth signal is used to control the third selector to connect the first input or the second input to the output. When the third selector selects that the first input is connected to the output, the third selector may output the test excitation to the input channel of the tested circuit in one clock cycle, and output the test response from the output channel of the tested circuit.

In a possible implementation, the test circuit further includes: a reset input bus, a reset output bus, and a plurality of fourth registers. A quantity of the fourth registers is equal to a quantity of registers coupled to the second input bus; the reset input bus is coupled to the reset output bus through the plurality of fourth registers, the reset input bus is configured to input a reset signal, and the reset output bus is configured to output, to the test circuit, the reset signal delayed by the plurality of fourth registers. A difference between a time at which the reset signal is input from the reset input bus and a time at which the reset signal is output from the reset output bus is equal to a difference between a time at which data is input from the input bus and a time at which the data is output from the output bus. For each core, a difference between a time at which the test circuit is started and a time at which the data arrives is the same, which facilitates calculation of a time at which the state machine of the test circuit in each core starts to output a capture enable signal.

In a possible implementation, the test circuit further includes a plurality of fifth registers, where the first input bus and the second input bus each are coupled to A fifth registers, and A is a positive integer. In this way, data input by each input bus is input to the test circuit after a same delay. When a transmission distance of the test bus is long, inconsistency of timing of data transmission on each input bus can be avoided. In this way, a transmission speed of the test bus is improved.

In a possible implementation, the test circuit further includes a plurality of sixth registers, where the first output bus and the second output bus each are coupled to B sixth registers, and B is a positive integer. In this way, the data output by each output bus is transmitted to a next core after a same delay. When the transmission distance of the test bus is long, inconsistency of timing of data transmission on each output bus can be avoided. In this way, the transmission speed of the test bus is improved.

In a possible implementation, the test circuit further includes a first selector. An output of the first selector is configured to be coupled to one first output bus or one second output bus; two inputs of the first selector are respectively coupled to one first input bus and one second input bus; or configured to be respectively coupled to two first input buses, or configured to be respectively coupled to two second input buses. The first selector may implement that the test circuit is in a pass-through mode, that is, a sequence number of the output bus is the same as a sequence number of the coupled input bus; or may implement that the test circuit is in a shift mode, that is, a sequence number of the output bus is in a shift relationship with a sequence number of the coupled input bus.

According to a second aspect, an integrated circuit is provided, including a plurality of cores. Each core includes a tested circuit and the test circuit according to the first aspect and any implementation of the first aspect, and test circuits of the plurality of cores are coupled through a test bus.

According to a third aspect, an electronic device is provided, including a printed circuit board and the integrated circuit according to the second aspect that is disposed on the printed circuit board.

According to a fourth aspect, a method for generating a test circuit is provided. The method includes: obtaining a bandwidth of an input bus or a bandwidth of an output bus of a test bus, and a bandwidth of an input channel and a bandwidth of an output channel of a tested circuit in each core; and determining, based on the bandwidth of the input bus or the bandwidth of the output bus of the test bus, and the bandwidth of the input channel and the bandwidth of the output channel of each tested circuit, a quantity of dynamic routing units DRUs or registers coupled to each input bus in each test circuit, and generating the test circuit according to the first aspect and any implementation of the first aspect.

In a possible implementation, a quantity K of dynamic routing units or registers coupled to each input bus in a test

$$K = \lceil Max(CI,CO)/n \rceil$$

circuit in each core is obtained in the following manner: , where $CI$ represents a bandwidth of an input channel of a tested circuit in a core, CO represents a bandwidth of an output channel of the tested circuit in the core, and n represents the bandwidth of the input bus or the bandwidth of the output bus.

According to a fifth aspect, a circuit test method is provided, and is used to test a tested circuit by using the test circuit according to the first aspect and any implementation of the first aspect. The method includes: generating configuration information and test excitation, where the configuration information is used to configure a frequency division ratio of the test circuit and select an input channel for coupling a first dynamic routing unit DRU or a second DRU to the tested circuit, to input the test excitation to the tested circuit; inputting the configuration information and the test excitation into the tested circuit; receiving a test response of the tested circuit; and determining, based on the test response, whether the tested circuit is normal.

According to a sixth aspect, a computer-readable storage medium is provided. The computer-readable storage medium stores instructions, and when the instructions are executed by a processor, the method according to the second aspect is performed.

According to a seventh aspect, a computer program product including instructions is provided. When the instructions are executed by a processor, the method according to the second aspect is performed.

For technical effects of the second aspect to the seventh aspect, refer to technical effects of any one of the first aspect and the implementations of the first aspect.

## BRIEF DESCRIPTION OF DRAWINGS

FIG. 1 is a schematic diagram of a structure of an integrated circuit according to an embodiment of this application;
FIG. 2 is a schematic diagram of a structure of a core in an integrated circuit according to an embodiment of this application;
FIG. 3 is a schematic diagram of a structure of a core in another integrated circuit according to an embodiment of this application;
FIG. 4 is a schematic diagram of a structure of a core in still another integrated circuit according to an embodiment of this application;
FIG. 5 is a schematic diagram of a structure of a dynamic routing unit according to an embodiment of this application;
FIG. 6 is a schematic diagram of a structure of a plurality of cores in an integrated circuit according to an embodiment of this application;
FIG. 7 is a schematic diagram 1 of transmitting test excitation in a plurality of cores according to an embodiment of this application;
FIG. 8 is a schematic diagram 2 of transmitting test excitation in a plurality of cores according to an embodiment of this application;
FIG. 9 is a schematic diagram 3 of transmitting test excitation in a plurality of cores according to an embodiment of this application;
FIG. 10 is a schematic diagram 4 of transmitting test excitation in a plurality of cores according to an embodiment of this application;
FIG. 11 is a schematic diagram 5 of transmitting test excitation in a plurality of cores according to an embodiment of this application;

FIG. 12 is a schematic diagram 6 of transmitting test excitation in a plurality of cores according to an embodiment of this application;

FIG. 13 is a schematic diagram of timing of signals according to an embodiment of this application;

FIG. 14 is a schematic flowchart of a test circuit generation method according to an embodiment of this application; and

FIG. 15 is a schematic flowchart of a circuit test method according to an embodiment of this application.

## DESCRIPTION OF EMBODIMENTS

The terms "first", "second" and the like in embodiments of this application are merely intended for description, and shall not be understood as an indication or implication of relative importance or an implicit indication of a quantity of indicated technical features. Therefore, features defined with "first", "second", and the like may explicitly or implicitly include one or more such features.

It should be noted that, in this application, terms such as "an example" or "for example" are used to represent giving an example, an illustration, or a description. Any embodiment or design scheme described as an "example" or "for example" in this application should not be explained as being more preferred or having more advantages than another embodiment or design scheme. Exactly, use of the term "example", "for example", or the like is intended to present a related concept in a specific manner.

In this application, unless otherwise specified and limited, the terms "coupling" and "connection" should be understood in a broad sense. For example, the terms "coupling" and "connection" may refer to a physical direct connection, or may refer to an electrical connection implemented through an intermediate medium, for example, a connection implemented through a resistor, an inductor, a capacitor, or another electronic component.

An embodiment of this application provides an electronic device. The electronic device includes a printed circuit board and an integrated circuit disposed on the printed circuit board. The electronic device may be electronic products such as a mobile phone (mobile phone), a tablet computer (pad), a computer, an intelligent wearable product (for example, a smartwatch or a smart band), a virtual reality (virtual reality, VR) terminal device, and an augmented reality (augmented reality, AR) terminal device. A specific form of the electronic device is not limited in embodiments of this application.

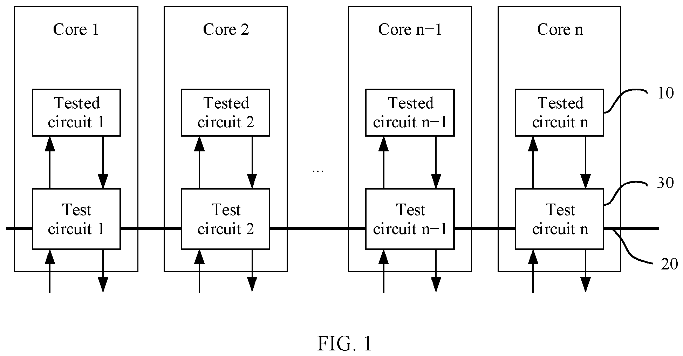

As shown in FIG. 1, the integrated circuit in the electronic device includes a plurality of cores, each core includes a tested circuit 10 and a test circuit 30 corresponding to the tested circuit 10, and the tested circuit 10 and the corresponding test circuit 30 may be disposed separately or integrated together. Different tested circuits 10 in each integrated circuit may implement a same function or different functions. Test circuits 30 of the plurality of cores are coupled through a test bus 20 of the test circuit 30, test excitation input by the test bus 20 is input to the corresponding tested circuit 10 through the test circuit 30, and a test response of the tested circuit 10 is output through the test bus 20 of the test circuit 30, to test functions of a plurality of tested circuits 10.

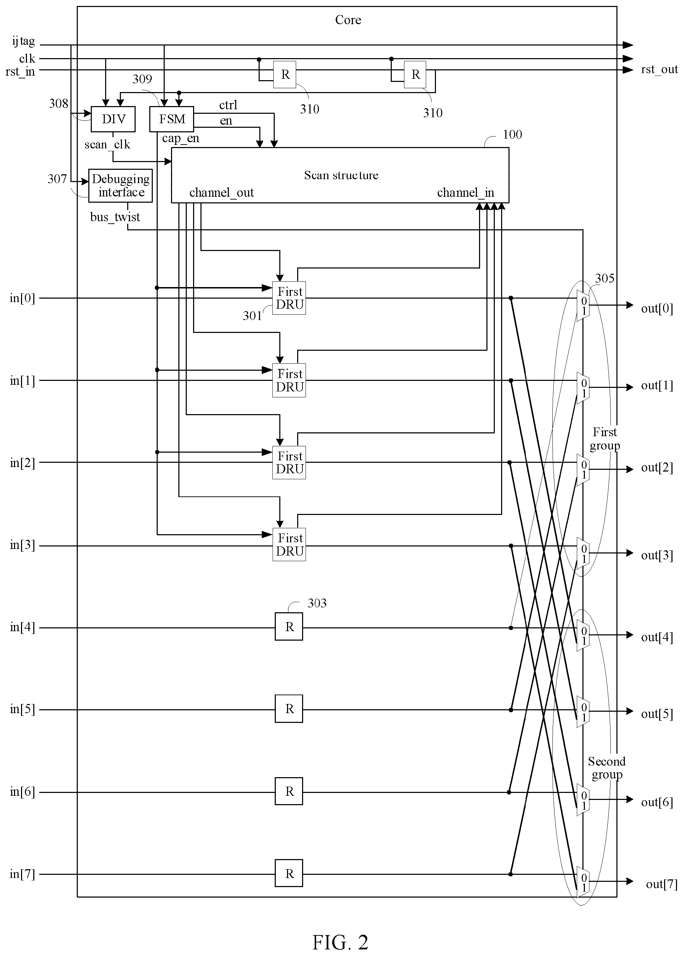

As shown in FIG. 2, in a core, the foregoing tested circuit 10 may include a scan structure 100. The foregoing test bus 20 may include a plurality of input buses (for example, in[0] to in[7]), a plurality of output buses (for example, out[0] to out[7]), an internal joint test action group (internal joint test action group, IJTAG) (IEEE 1687 standard) bus ijtag, a reset input bus rst_in, a reset output bus rst_out, and a clock bus clk. In addition to the test bus 20, the foregoing test circuit 30 further includes a plurality of first dynamic routing units (dynamic routing units, DRUs) 301, a plurality of first registers 303, a plurality of first selectors 305, a debugging interface 307, a frequency divider (divider, DIV) 308, a state machine (also referred to as a finite state machine (finite state machine, FSM)) 309, and a plurality of fourth registers 310.

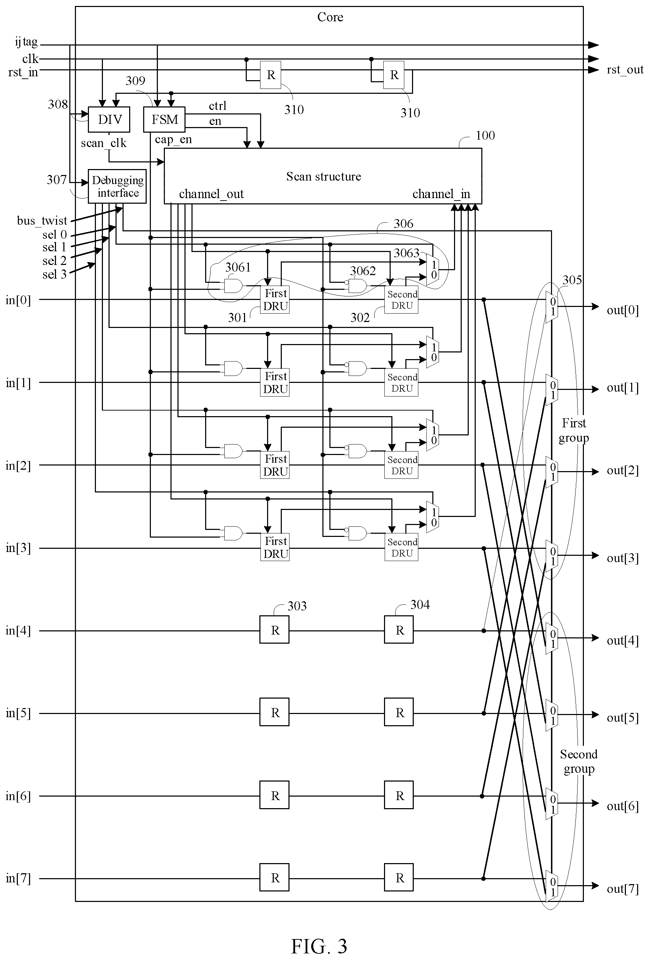

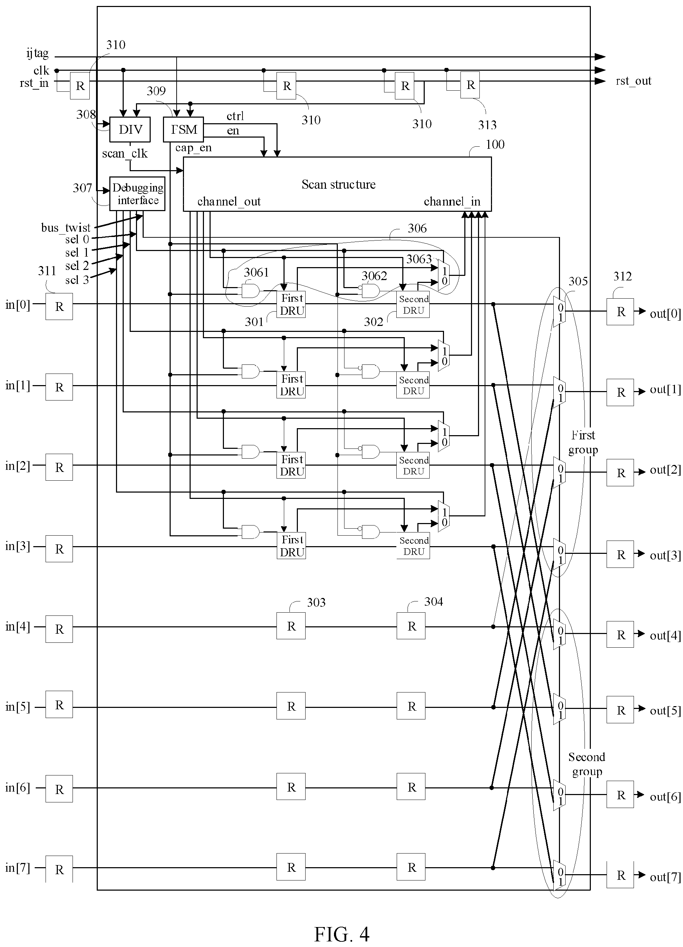

Optionally, as shown in FIG. 3 or FIG. 4, the foregoing test circuit 30 further includes a plurality of second DRUs 302 coupled to a plurality of first DRUs 301, a plurality of selection circuits 306, and a plurality of second registers 304 coupled to a plurality of first registers 303. Optionally, as shown in FIG. 4, the test circuit 30 further includes a plurality of fifth registers 311, a plurality of sixth registers 312, and a plurality of seventh registers 313.

As shown in FIG. 2 to FIG. 4, a tested circuit (the scan structure 100) includes a plurality of input channels channel_in and a plurality of output channels channel_out. Each input channel channel_in is used to input one bit of test excitation. After the test excitation is run in the tested circuit (the scan structure 100), a test response is output through the output channel channel_out, and each output channel channel_out is used to output one bit of the test response. Bandwidths of the input channel channel_in and the output channel channel_out may be the same or different. An example in which a bandwidth of the input channel channel_in and a bandwidth of the output channel channel_out each are 4 is used in this application, but is not intended to limit this application.

As shown in FIG. 2 to FIG. 4, a plurality of inputs of the frequency divider 308 are separately coupled to an IJTAG bus ijtag, a clock bus clk, and a reset output bus rst_out, and an output of the frequency divider 308 is coupled to a tested circuit (the scan structure 100). A debugging signal from the IJTAG bus ijtag is used to control a frequency division ratio of the frequency divider 308, and a reset signal from the reset output bus rst_out is used to control start and stop of the frequency divider 308. The frequency divider 308 obtains a frequency division clock signal by performing frequency division on a clock signal from the clock bus clk, and outputs the frequency division clock signal to the tested circuit (the scan structure 100) through a scanning clock bus scan_clk, to drive the tested circuit (the scan structure 100) to run. A

$$K = \lceil Max(CI,CO)/n \rceil$$

formula for calculating the frequency division ratio K of the frequency divider 308 is: . CI represents a bandwidth of an input channel channel_in of a tested circuit (the scan structure 100) in a core, CO represents a bandwidth of an output channel channel_out of a tested circuit (the scan structure 100) in a core, and n represents a bandwidth of an input bus in or a bandwidth of an output bus out. It should be noted that K values of cores calculated according to the formula may be different. When a plurality of cores are coupled through a test bus, a greatest value among K values of all cores is selected as a final K value of each core, to ensure that transmission delays of the cores are the same, and reduce complexity of test excitation. An example in which K is 2 is mainly used to describe this application, but is not intended to limit this application.

As shown in FIG. 2 to FIG. 4, an input of a debugging interface 307 is coupled to the IJTAG bus ijtag, and an output of the debugging interface 307 is coupled to a control end of the plurality of first selectors 305 through a bus twist bus bus_twist. The debugging interface 307 outputs a twist control signal to the control end of the first selector 305 based on the debugging signal from the IJTAG bus ijtag through the bus twist bus bus_twist. As shown in FIG. 3 and FIG. 4, a plurality of other outputs of the debugging interface 307 are separately coupled to a control end of a second selector 3063, a first input of a first AND gate 3061, and a first input of a second AND gate 3062 of each selection circuit 306 through selection lines sel (for example, sel 0 to sel 3). The debugging interface 307 outputs a selection signal to the first input of the first AND gate 3061, the first input of the second AND gate 3062, and the control end of the second selector 3063 through selection lines sel (for example, sel 0 to sel 3) based on the debugging signal from the IJTAG bus ijtag.

As shown in FIG. 2 to FIG. 4, a plurality of inputs of an FSM 309 are separately coupled to the IJTAG bus ijtag and the reset output bus rst_out, the FSM 309 is coupled to a tested circuit (the scan structure 100) through a control line ctrl and a scanning enable line en, and the FSM 309 is coupled to the first DRU 301 through a capture enable line cap_en. As shown in FIG. 3 and FIG. 4, the FSM 309 is coupled to a second input of the first AND gate 3061 and a second input of the second AND gate 3062 of the selection circuit 306 through the capture enable line cap_en, and is further coupled to the first DRU 301 and the second DRU 302.

The debugging signal from the IJTAG bus ijtag is used to control state transition of the FSM 309, and the reset signal from the reset output bus rst_out is used to control start and stop of the FSM 309. The FSM 309 outputs a control signal to the tested circuit (the scan structure 100) through the control line ctrl, to control a scanning test state of the tested circuit (the scan structure 100). The FSM 309 outputs a scanning enable signal to the tested circuit (the scan structure 100) through the scanning enable line en, to enable or disable a scanning test mode of the tested circuit (the scan structure 100).

The FSM 309 outputs a capture enable signal through the capture enable line cap_en. For the structure shown in FIG. 2, the capture enable signal controls the first DRU 301 to transparently transmit data from the input bus in, or inputs stored test excitation to an input channel channel_in of the tested circuit (the scan structure 100) and outputs a test response from an output channel channel_out of the tested circuit (the scan structure 100). For FIG. 3 or FIG. 4, the capture enable signal is used to output capture enable signals to the second input of the first AND gate 3061 and the second input of the second AND gate 3062 of each selection circuit 306, to control, by using the selection circuit 306, the first DRU 301 or the second DRU 302 to transparently transmit data from the input bus in, or input the stored test excitation to the input channel channel_in of the tested circuit (the scan structure 100) and output the test response from the output channel channel_out of the tested circuit (the scan structure 100). Therefore, there are two states of the capture enable signal output by the FSM 309. For example, when the capture enable signal is at a low level ("0"), the first DRU 301 or the second DRU 302 is controlled to transparently transmit the data from the input bus in. When the capture enable signal is at a high level ("1"), the first DRU 301 or the second DRU 302 is controlled to output the stored test excitation to the input channel channel_in of the tested circuit (the scan structure 100), and outputs the test response from the output channel channel_out of the tested circuit (the scan structure 100) to the output bus out. The capture enable signal output by the FSM 309 changes periodically, so that a DRU and the tested circuit (the scan structure 100) may periodically exchange data at a toggle edge of the frequency division clock signal. This cycle is called a test cycle, and a length of the test cycle is equal to K*CLK, where K is the foregoing frequency division ratio, and CLK is a cycle of the clock signal of the clock bus clk. Timing of inputting the test excitation into the input channel channel_in of the tested circuit (the scan structure 100) from the first DRU 301 or the second DRU 302 matches the toggle edge of the frequency division clock signal. For details, refer to the following descriptions about the first DRU 301 and the second DRU 302.

Each selection circuit 306 includes the first AND gate 3061, the second AND gate 3062, and the second selector 3063, where the first input of the second AND gate 3062 performs phase inversion on the input signal. The first input of the first AND gate 3061 and the first input of the second AND gate 3062 are coupled to the control end of the second selector 3063, and are configured to input a selection signal (a third signal) from the debugging interface 307. The second input of the first AND gate 3061 and the second input of the second AND gate 3062 are coupled, and are configured to input a capture enable signal (a fourth signal) from the FSM 309. An output of the first AND gate 3061 is coupled to the first DRU 301, to output the first signal to the first DRU 301. An output of the second AND gate 3062 is coupled to the second DRU 302, to output a second signal to the second DRU 302. Two inputs of the second selector 3063 are respectively coupled to the first DRU 301 and the second DRU 302, and an output of the second selector 3063 is configured to be coupled to an input channel channel_in of the tested circuit (the scan structure 100), to select the first DRU 301 or the second DRU 302 to be coupled to an input channel channel_in of the tested circuit (the scan structure 100).

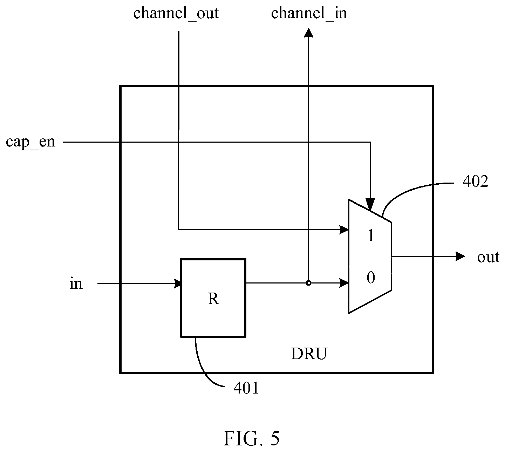

The selection circuit 306 is configured to select, based on the selection signal from the debugging interface 307, the first DRU 301 or the second DRU 302 to be coupled to the input channel channel_in of the tested circuit (the scan structure 100). FIG. 3 or FIG. 4 is used as an example. When a capture enable signal output by the FSM 309 through the capture enable line cap_en is at a high level ("1"), if the selection signal output by the debugging interface 307 through the selection line sel is at a high level ("1"), the first AND gate 3061 outputs a high level ("1"), and the second AND gate 3062 outputs a low level ("0") because the first input performs phase inversion, the second selector 3063 selects the first input to be connected to the output, so that a data output of a third register 401 (shown in FIG. 5) in the first DRU 302 is coupled to an input channel channel_in of the tested circuit. When a capture enable signal output by the FSM 309 through the capture enable line cap_en is at a high level ("1"), if the selection signal output by the debugging interface 307 through the selection line sel is at a low level ("0"), the first AND gate 3061 outputs a low level ("0"), the second AND gate 3062 outputs a high level ("1") because the first input performs phase inversion, and the second selector 3063 selects the second input to be connected to the output, so that a data output of a third register 401 (shown in FIG. 5) in the second DRU 303 is coupled to an input channel channel_in of the tested circuit.

Bandwidths of the input bus in and the output bus out are the same. For example, an example in which the bandwidth is 8 bits is used in this application, but is not intended to limit this application. The input bus in is configured to input test excitation or input a test response from a tested circuit in another core, and the output bus out is configured to output a test response of a tested circuit in the current core or transparently transmitted test excitation or test response. In this application, an input bus in coupled to a DRU (for example, the first DRU 301 and the second DRU 302) may be referred to as a first input bus in, for example, input buses in[0] to in[3] in FIG. 2 to FIG. 4. An output bus out coupled to a DRU (for example, the first DRU 301 and the second DRU 302) may be referred to as a first output bus out, for example, output buses out[0] to out[3] in FIG. 2 to FIG. 4 when the first selector 305 connects the first input to the output. An input bus in that is not coupled to the DRU is referred to as a second input bus in, for example, input buses in[4] to in[7] in FIG. 2 to FIG. 4. An output bus out that is not coupled to the DRU is referred to as a second output bus out, for example, output buses out[4] to out[7] in FIG. 2 to FIG. 4 when the first selector 305 connects the first input to the output. A ratio of the first input bus in to the second input bus in is not limited in this application. There may be a plurality of first input buses in and a plurality of second input buses in. A ratio of the first output bus out to the second output bus out is not limited. There may be a plurality of first input buses in and a plurality of second input buses in.

The first selector 305 includes a first input, a second input, and an output, where the output of the first selector 305 is coupled to one first output bus out or one second output bus out. Two inputs of the first selector 305 are respectively coupled to one first input bus in and one second input bus in; or are respectively coupled to two first input buses in; or are respectively coupled to two second input buses in. The first selector 305 is configured to connect the first input or the second input to the output.

The first input bus in is coupled to an input channel channel_in of the tested circuit (the scan structure 100) through the first DRU 301 (and the second DRU 302 and the selection circuit 306). An output channel channel_out of the tested circuit (the scan structure 100) is coupled to the first input of the first selector 305 through the first DRU 301 (and the second DRU 302), and then coupled to the first output bus out. From another perspective, the first input bus in is coupled to the first output bus out through the first DRU 301 (and the second DRU 302) and the first selector 305. The second input bus in is coupled to the second input of the first selector 305 through the first register 303 (and the second register 304), and then coupled to the second output bus out.

In one clock cycle: a bit of test excitation from the first input bus in is output to one input channel channel_in of the tested circuit (the scan structure 100) through the first DRU 301 (and one second DRU 302), and a bit of a test response from one output channel channel_out of the tested circuit (the scan structure 100) is output to the first output bus through the first DRU 301 (and one second DRU 302); or a bit of data (test excitation or a test response) from the first input bus in is output (that is, transparently transmitted) to the first output bus out through the first DRU 301 (and one second DRU 302), and a bit of data (test excitation or a test response) from the second input bus in is output (that is, transparently transmitted) to the second output bus out through the first register 303 (and one second register 304).

As shown in FIG. 2 to FIG. 4, when a twist control signal output by the debugging interface 307 to the control end of the first selector 305 through the bus twist line bus_twist is at low level ("0"), the first selector 305 in a first group (for example, as shown in the "first group") selects the first input to be connected to the output, so that the first DRUs 301 (and the second DRUs 302) coupled to the first input buses in (for example, input buses in[0] to in[3]) are coupled to the output buses out[0] to out[3] (namely, the first output buses out). The first selector 305 in a second group (for example, as shown in the "second group") selects the second input to be connected to the output, so that the first registers 303 and the second registers 304 coupled to the second input buses (for example, the input buses in[4] to in[7] in FIG. 3 or FIG. 4) are coupled to the output buses out[4] to out[7] (namely, the second output buses out). In this case, the mode is a pass-through mode, that is, a sequence number of the output bus out is the same as a sequence number of the coupled input bus in.

Further, FIG. 3 or FIG. 4 is used as an example. When a twist control signal output by the debugging interface 307 to the control end of the first selector 305 through the bus twist line bus_twist is at a high level ("1"), the first selector 305 in a first group (for example, as shown by the "first group" in FIG. 3 or FIG. 4) selects the second input to be connected to the output, so that the first registers 303 and the second registers 304 coupled to the second input buses (for example, the input buses in[4] to in[7] in FIG. 3 or FIG. 4) are coupled to the output buses out[0] to out[3] (namely, the second output buses out). The first selector 305 in a second group (for example, the "second group" in FIG. 3 or FIG. 4) selects the second input to be connected to the output, so that the first DRUs 301 and the second DRUs 302 coupled to the first input buses in (for example, the input buses in[0] to in[3] in FIG. 3 or FIG. 4) are coupled to the output buses out[4] to out[7] (namely, the first output buses out). In this case, the mode is a shift mode, that is, a shift relationship exists between a sequence number of the output bus out and a sequence number of the coupled input bus in.

As shown in FIG. 5, the first DRU 301 or the second DRU 302 described above includes a third register 401 and a third selector 402. A data input of the third register 401 is configured to be coupled to a first input bus in, a data output of the third register 401 is configured to be separately coupled to a second input of the third selector 402 and an input channel channel_in of a tested circuit (a scan structure 100). The third register 401 is configured to store data input from the first input bus in, and a first input of the third selector 402 is configured to be coupled to an output channel channel_out of the tested circuit (the scan structure 100). A control end of the third selector 402 is configured to be coupled to a capture enable line cap_en of an FSM 309. When applied to the first DRU 301 in FIG. 2, the control end of the third selector 402 may be directly coupled to the capture enable line cap_en of the FSM 309. When applied to the first DRU 301 in FIG. 3 and FIG. 4, the control end of the third selector 402 is indirectly coupled to the capture enable line cap_en of the FSM 309 by coupling to the output of the first AND gate 3061 described above, and inputs a first signal from the first AND gate 3061. When applied to the second DRU 302 in FIG. 3 and FIG. 4, the control end of the third selector 402 is indirectly coupled to the capture enable line cap_en of the FSM 309 by coupling to the output of the second AND gate 3062 described above, and inputs a second signal from the second AND gate 3062. The first signal or the second signal is used to control the third selector 402 to connect the first input or the second input to the output. The output of the third selector 402 is configured to be coupled to an output bus out. When a low level ("0") is input to the control end of the third selector 402, the third selector 402 connects the second input to the output, so that the data stored in the third register 401 is output to an output bus out. When a high level (for example, "1") is input to the control end of the third selector 402, the third selector 402 connects the first input to the output, so that a bit of a test response from an output channel channel_out of the tested circuit (the scan structure 100) is output to the first output bus out.

Specifically, when the DRU is used as the first DRU 301 in FIG. 2, the data input of the third register 401 is coupled to a first input bus in, and the data output of the third register 401 is coupled to both the second input of the third selector 402, and the first input of a second selector 3063, to be coupled to an input channel channel_in of the tested circuit (the scan structure 100) through the second selector 3063. The third register 401 is configured to store the data input from the first input bus in. The first input of the third selector 402 is coupled to an output channel channel_out of the tested circuit (the scan structure 100), the control end of the third selector 402 is coupled to the capture enable line cap_en of the FSM 309, and the output of the third selector 402 is coupled to the data input of the third register 401 in the second DRU 302, to be coupled to a first output bus out.

When the DRU is used as the first DRU 301 in FIG. 3 and FIG. 4, the data input of the third register 401 is coupled to a first input bus in, and the data output of the third register 401 is coupled to both the second input of the third selector 402 and the first input of the second selector 3063, to be coupled to an input channel channel_in of the tested circuit (the scan structure 100) through the second selector 3063. The third register 401 is configured to store the data input from the first input bus in. The first input of the third selector 402 is coupled to an output channel channel_out of the tested circuit (the scan structure 100), the control end of the third selector 402 is coupled to an output of the first AND gate 3061, and an output of the third selector 402 is coupled to the data input of the third register 401 in the second DRU 302, to be coupled to an output bus out through the second DRU 302.

When the DRU is used as the second DRU 302 in FIG. 3 and FIG. 4, the data input of the third register 401 is coupled to an output of a third selector in the first DRU 301, to be coupled to a first input bus in through the first DRU 301. The data output of the third register 401 is coupled to both a second input of the third selector 402 and a second input of the second selector 3063, to be coupled to an input channel channel_in of the tested circuit (the scan structure 100) through the second selector 3063. The third register 401 is configured to store data input from the first DRU 301. A first input of the third selector 402 is coupled to an output channel channel_out of the tested circuit (the scan structure 100), a control end of the third selector 402 is coupled to an output of the second AND gate 3062, and an output of the third selector 402 is coupled to the first selector 305, to be coupled to an output bus out through the first selector 305.

The following describes a working principle of a first DRU 301 coupled to a first input bus in in FIG. 2.

When the capture enable signal output by the FSM 309 through the capture enable line cap_en is at a low level ("0"), the first DRU 301 is in a pass-through mode, and in each clock cycle, the first DRU 301 outputs data (for example, a bit of test excitation or a bit of a test response) from one first input bus in. When the capture enable signal output by the FSM 309 through the capture enable line cap_en is at a high level ("1"), in each clock cycle, the first DRU 301 outputs a bit of test excitation from one first input bus in to one input channel channel_in of the tested circuit (the scan structure 100), and outputs one bit of a test response from one output channel channel_out of the tested circuit (the scan structure 100).

In addition, for the first register 303 coupled to the second input bus in, in each clock cycle, the first register 303 outputs data (for example, a bit of test excitation or a bit of a test response) from one second input bus in. Therefore, data transmitted by the first input bus is consistent with data transmitted by the second input bus in terms of timing. This implements consistency of timing of data transmission on the test bus, and improves a transmission rate of the test bus.

The following describes working principles of the first DRU 301, the second DRU 302, and the selection circuit 306 that are coupled to one first input bus in in FIG. 3 and FIG. 4.

In a first clock cycle, when the capture enable signal output by the FSM 309 through the capture enable line cap_en is at a low level ("0"), the first DRU 301 and the second DRU 302 are in a pass-through mode, and the selection circuit 306 does not output, to an input channel of the tested circuit (the scan structure 100), a bit of test excitation stored in the first DRU 301 or the second DRU 302. The second DRU 302 outputs stored data (for example, a bit of test excitation or a bit of a test response) to the output bus out, and the first DRU 301 outputs data (for example, a bit of test excitation or a bit of a test response) from one first input bus in to the second DRU 302 for storage.

In a second clock cycle, when the capture enable signal output by the FSM 309 through the capture enable line cap_en is at a high level ("1"), if a selection signal output by the debugging interface 307 through the selection line sel is at a low level ("0"), a first signal output by the output of the first AND gate 3061 is at a low level ("0"), that is, a low level ("0") is input to the control end of the third selector 402 of the first DRU 301. One bit of test excitation that is from the first input bus in and that is stored in the third register 401 of the first DRU 301 is output, through the third selector 402 of the first DRU 301, to the third register 401 of the second DRU 302 for storage. A second signal output by the second AND gate 3062 is at a high level ("1") because the first input performs phase inversion, that is, the high level ("1") is input to the control end of the third selector 402 of the second DRU 302. The third selector 402 of the second DRU 302 outputs a bit of a test response from an output channel channel_out of the tested circuit (the scan structure 100) to the first selector 305, so that the bit is output to an output bus out through the first selector 305. A bit that is of test excitation from the first input bus in and that is stored in the third register 401 of the second DRU 302 is output to the second input of the second selector 3063. A low level ("0") is input to the control end of the second selector 3063, and the second selector 3063 outputs a bit of test excitation stored in the second DRU 302 to an input channel channel_in of the tested circuit (the scan structure 100).

In other words, in the second clock cycle, the selection circuit 306 selects the second DRU 302 to be coupled to an input channel channel_in of the tested circuit (the scan structure 100), the second DRU 302 outputs one bit of the stored test excitation to one input channel channel_in of the tested circuit (the scan structure 100), receives a bit of the test response from an output channel channel_out of the tested circuit (the scan structure 100), and outputs the bit to an output bus out.

Alternatively, in the second clock cycle, when the capture enable signal output by the FSM 309 through the capture enable line cap_en is at a high level ("1"), if a selection signal output by the debugging interface 307 through the selection line sel is at a high level ("1"), a first signal output by the output of the first AND gate 3061 is at a high level ("1"), that is, a high level ("1") is input to the control end of the third selector 402 of the first DRU 301. The third selector 402 of the first DRU 301 outputs one bit of the test response from the output channel channel_out of the tested circuit (the scan structure 100) to the data input of the third register 401 in the second DRU 302. A bit that is of test excitation from the first input bus in and that is stored in the third register 401 of the first DRU 301 is output to the first input of the second selector 3063. A high level ("1") is input to the control end of the second selector 3063, and the second selector 3063 outputs a bit of test excitation stored in the first DRU 301 to an input channel channel_in of the tested circuit (the scan structure 100). The second AND gate 3062 outputs a low level ("0") of a second signal because the first input performs phase inversion, that is, the low level ("0") is input to the control end of the third selector 402 of the second DRU 302, and the third selector 402 of the second DRU 302 connects the second input to the output, and outputs, to an output bus out, a bit of the test response that is from the first DRU 301 and that is stored in the third register 401 of the second DRU 302.

In other words, in the second clock cycle, the selection circuit 306 selects the first DRU 301 to be coupled to an input channel channel_in of the tested circuit (the scan structure 100), the first DRU 301 outputs one bit of the test excitation from one first input bus in to one input channel channel_in of the tested circuit (the scan structure 100), receives one bit of the test response from an output channel channel_out of the tested circuit (the scan structure 100), and outputs the bit to the second DRU 302 for storage.

The following describes working principles of the first DRU 301, the second DRU 302, and the selection circuit 306 that are coupled to N first input buses in, and describes how to input N-bit test excitation to N input channels channel_in of the tested circuit (the scan structure 100) through the first DRU 301, the second DRU 302, and the selection circuit 306 that are coupled to the N first input buses in.

When the N bits of test excitation are input from the N first input buses in in the first clock cycle, in the first clock cycle, the capture enable signal output by the FSM 309 through the capture enable line cap_en is at a low level ("0"), and the first DRU 301 coupled to the N first input buses in may respectively output the N bits of test excitation to the second DRU 302 coupled to the N first input buses in for storage. In the second clock cycle, the capture enable signal output by the FSM 309 through the capture enable line cap_en is at a high level ("1"), N selection signals output by the debugging interface 307 through N selection lines sel are at low levels ("0"), and second DRUs 302 coupled to the N input buses are coupled to N input channels channel_in of the tested circuit (the scan structure 100), and N bits of stored test excitation are output to the N input channels channel_in of the tested circuit (the scan structure 100), receive N bits of a test response from N output channels channel_out of the tested circuit (the scan structure 100), and output the N bits to the N output buses out.

When the N bits of the test excitation are input from the N first input buses in in the second clock cycle, in the second clock cycle, the capture enable signal output by the FSM 309 through the capture enable line cap_en is at a high level ("1"), and N selection signals output by the debugging interface 307 through the N selection lines sel are at a high level ("1"). The first DRU 301 coupled to the N first input buses in outputs the N bits of the test excitation to the N input channels channel_in of the tested circuit (the scan structure 100), receives the N bits of the test response from the N output channels channel_out of the tested circuit (the scan structure 100), and outputs the N bits to the second DRU 302 coupled to the N first input buses in for storage.

When the first n bits of the test excitation are input from the first n first input buses in in the first clock cycle, and the last N-n bits of the test excitation are input from the last N-n first input buses in in the second clock cycle, in the first clock cycle, the capture enable signal output by the FSM 309 through the capture enable line cap_en is at a low level ("0"). The first DRUs 301 coupled to the first n first input buses in may respectively output the first n bits of test excitation to the second DRUs 302 coupled to the n first input buses in for storage. In the second clock cycle, the capture enable signal output by the FSM 309 through the capture enable line cap_en is at a high level ("1"), N selection signals output by the debugging interface 307 through the first n selection lines sel are at low levels ("0"), and the second DRU 302 coupled to the n input buses outputs n bits of stored test excitation to n input channels channel_in of the tested circuit (the scan structure 100), receives n bits of a test response from n output channels channel_out of the tested circuit (the scan structure 100), and outputs the n bits to n output buses out. N-n selection signals output by the debugging interface 307 through the last N-n selection lines sel are at high levels ("1"), and the first DRU 301 coupled to the N-n first input buses in outputs the last N-n bits of test excitation to a remaining N-n input channel channel_in of the tested circuit (the scan structure 100). The last N-n bits of the test response are received from the remaining N-n output channels channel_out of the tested circuit (the scan structure 100), and are output to the second DRU 302 coupled to the N-n first input buses in for storage.

In a conventional technology, because a quantity of pins (namely, bus bandwidths) of a chip for inputting test excitation and outputting test responses is limited, to make full use of the bus bandwidths, complete test excitation output to a core may be split into a plurality of parts and transmitted to the bus in a time-sharing manner. If these parts are input to an input channel of a tested circuit, an incorrect test response is generated. For the test circuit shown in FIG. 3 and FIG. 4, one test cycle may include two clock cycles. No matter in which clock cycle the test excitation is input, and no matter whether the test excitation is separately input in two clock cycles, the test excitation may be output to the input channel channel_in of the tested circuit (the scan structure 100) in the second clock cycle, so that all parts of the test excitation that are input in a time-sharing manner are input to the input channel of the tested circuit at the same time, and this avoids generating an incorrect test response.

An example in which each first input bus in is coupled to two DRUs and each second input bus is coupled to two registers is used in this application, but is not intended to limit this application. A frequency division ratio

$$K = \lceil Max(CI, CO)/n \rceil$$

of the frequency divider 308 may be used as a quantity of DRUs coupled to each first input bus in and a quantity of registers coupled to each second input bus.

A plurality of fourth registers 310 are coupled between a reset input bus rst_in and a reset output bus rst_out. The reset input bus rst_in is configured to input a reset signal, and the reset output bus rst_out is configured to output, to the test circuit, a reset signal delayed by the plurality of fourth registers 310. A quantity of the fourth registers 310 is the same as a quantity of registers coupled to the second input bus in (or a quantity of DRUs and registers coupled to the first input bus in). For example, in FIG. 2 and FIG. 3, the quantity of fourth registers 310 is 2. The frequency division ratio of the frequency divider 308 is adjusted, so that a difference between a time at which the reset signal is input from the reset input bus rst_in and a time at which the reset signal is output from the reset output bus rst_out is equal to a difference between a time at which data is input from the input bus in and a time at which the data is output from the output bus out. For each core, a difference between a time at which the test circuit is started and a time at which the data arrives is the same, which facilitates calculation of time at which the FSM 309 of the test circuit in each core starts to output a capture enable signal. The frequency divider 308 and the FSM 309 are in a reset state when the reset signal is effective. When the reset signal is ineffective, the frequency divider 308 and the FSM 309 start to work at the same time. Correspondingly, the driven first DRU 301, second DRU 302, and selection circuit 306 also start to work.

As shown in FIG. 4, the input buses in (the first input bus in and the second input bus in) each may be coupled to A fifth registers 311, where A is a positive integer. As a result, data input by each input bus in is input to the test circuit after a same delay. When a transmission distance of the test bus is long, inconsistency of timing of data transmission on each input bus can be avoided. In this way, a transmission speed of the test bus is improved. The fifth register 311 may be located inside a core or outside a core. It should be noted that, a quantity of fourth registers 310 coupled between the reset input bus rst_in and the reset output bus rst_out also needs to be increased by A accordingly, so that the difference between the time at which the reset signal is input from the reset input bus rst_in and the time at which the reset signal is output from the reset output bus rst_out is equal to the difference between the time at which the data is input from the input bus in and the time at which the data is output from the output bus out.

As shown in FIG. 4, the output buses out (the first output bus out and the second output bus out) each may be coupled to B sixth registers 312, and the reset output bus rst_out may further be coupled to B seventh registers 313, where B is a positive integer. As a result, data output by each output bus and a reset signal are transmitted to a next core after a same delay. When the transmission distance of the test bus is long, inconsistency of timing of data transmission on each output bus and the reset output bus can be avoided. In this way, the transmission speed of the test bus is improved. The sixth register 312 and the seventh register 313 may be located inside or outside the core.

According to the foregoing test circuit provided in this embodiment of this application, a quantity of DRUs coupled to each first input bus in is the same as a quantity of registers coupled to each second input bus, so that a delay of outputting test excitation to a tested circuit in a current core through a DRU and outputting a test response through the DRU, a delay of transparently transmitting data through the DRU, and a delay of transparently transmitting data through a register coupled to the second input bus in are the same. This implements consistency of timing of data transmission on the test bus, and improves a transmission rate of the test bus.

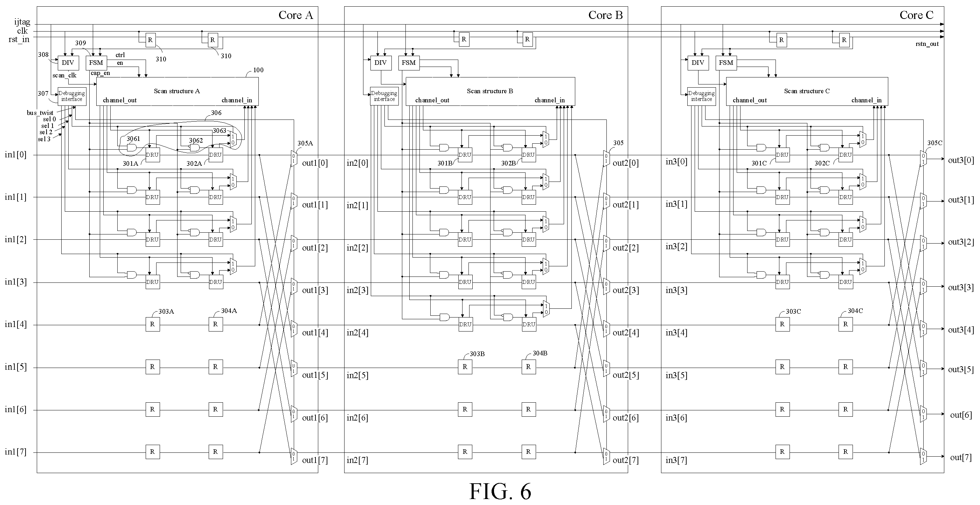

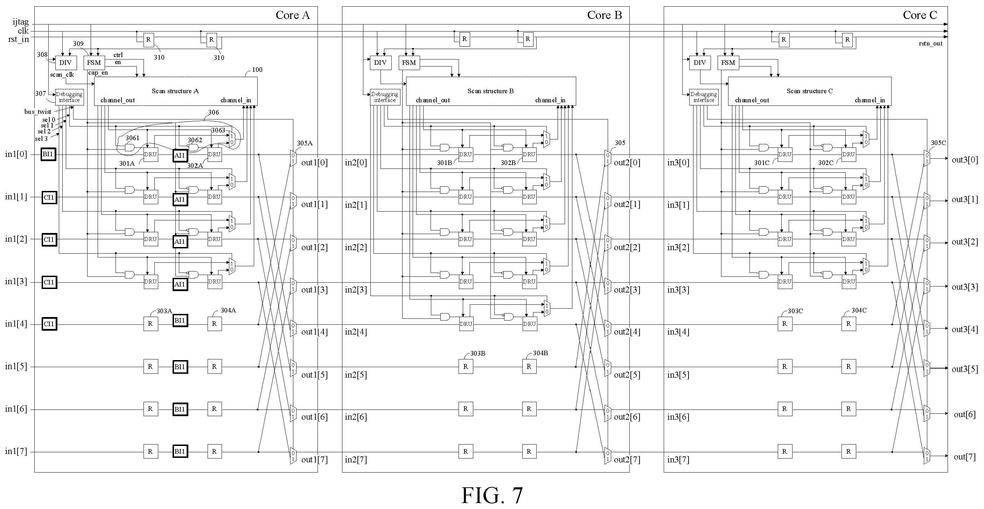

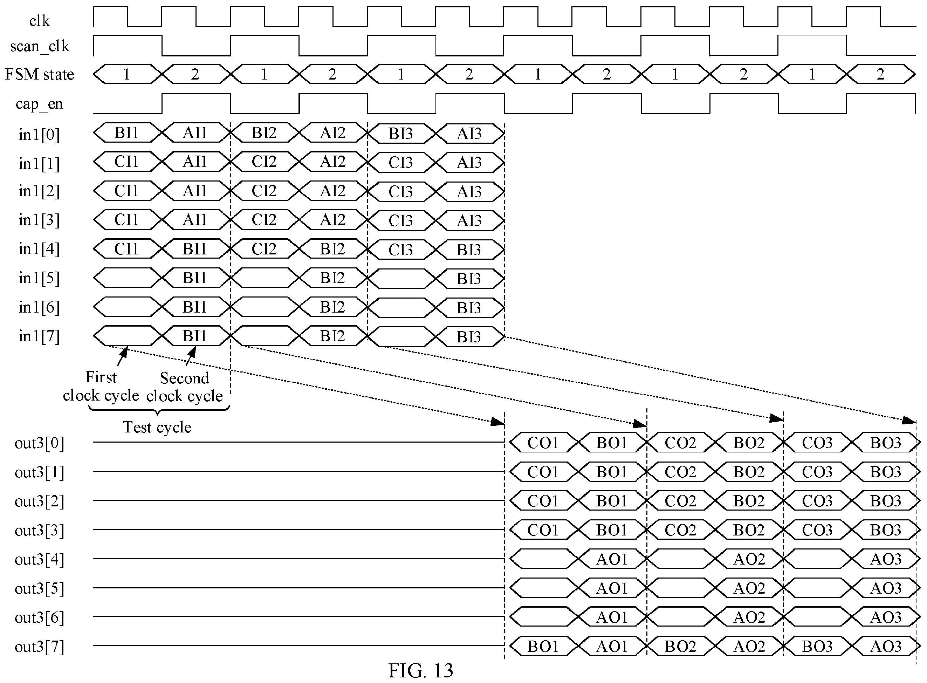

With reference to FIG. 6 to FIG. 13, an example in which an output bus of a test circuit in a previous core is serially coupled to an input bus of a test circuit in a next core is used below to describe a working principle of the integrated circuit shown in FIG. 3. For a timing diagram of FIG. 7 to FIG. 12, refer to FIG. 13.

As shown in FIG. 6, it is assumed that a core A includes a scan structure A, a core B includes a scan structure B, and a core C includes a scan structure C. Bandwidths of an input channel channel_in and an output channel channel_out of the scan structure A each are 4, bandwidths of an input channel channel_in and an output channel channel_out of the scan structure B each are 5, and bandwidths of an input channel channel_in and an output channel channel_out of the scan structure C each are 4. Input buses of the core A are in1[0] to in1[7], output buses of the core A are out1[0] to out1[7], the input buses in1[0] to in1[3] of the core A are coupled to a first DRU 301A and a second DRU 302A, and the input buses in1[4] to in1[7] of the core A are coupled to a first register 303A and a second register 304A. Input buses of the core B are in2[0] to in2[7], output buses of the core B are out2[0] to out2[7], the input buses in2[0] to in2[4] of the core B are coupled to a first DRU 301B and a second DRU 302B, and the input buses in2[5] to in2[7] of the core B are coupled to a first register 303B and a second register 304B. Input buses of the core C are in3[0] to in3[7], output buses of the core C are out3[0] to out3[7], the input buses in3[0] to in3[3] of the core C are coupled to a first DRU 301C and a second DRU 302C, and the input buses in3[4] to in3[7] of the core C are coupled to a first register 303C and a second register 304C.

For example, as shown in Table 1, it is assumed that scan structure A to scan structure C are tested, AI1 represents test excitation input by the scan structure A in the 1st test cycle, BI1 represents test excitation input by the scan structure B in the 1st test cycle, and CI1 represents test excitation input by the scan structure C in the 1st test cycle. AI2 represents test excitation input by the scan structure A in the 2nd test cycle, BI2 represents test excitation input by scan structure B in the 2nd test cycle, and CI2 represents test excitation input by the scan structure C in the 2nd test cycle. AI3 represents test excitation input by the scan structure A in the 3rd test cycle, BI3 represents test excitation input by the scan structure B in the 3rd test cycle, and CI3 represents test excitation input by the scan structure C in the 3rd test cycle.

It should be noted that, when tested circuits in some cores do not participate in a scanning test, the tested circuits may be configured to be in a pass-through mode, so that transparently transmitted test excitation or test responses are continuously transmitted. In addition, no transmission resource is reserved for the test excitation of the tested circuit on the test bus, to make full use of the transmission bandwidth of the test bus.

Table 1

|  | ... | 6 | 5 | 4 | 3 | 2 | 1 |
|---|---|---|---|---|---|---|---|
| in1[0] | ... | BI3 | AI3 | BI2 | AI2 | BI1 | AI1 |
| inl[1] | ... | CI3 | AI3 | CI2 | AI2 | CI1 | AI1 |
| in1[2] | ... | CI3 | AI3 | CI2 | AI2 | CI1 | AI1 |
| in1[3] | ... | CI3 | AI3 | CI2 | AI2 | CI1 | AI1 |
| in1[4] | ... | CI3 | BI3 | CI2 | BI2 | CI1 | BI1 |
| in1[5] | ... |  | BI3 |  | BI2 |  | BI1 |
| in1[6] | ... |  | BI3 |  | BI2 |  | BI1 |

(continued)

|        | ... | 6 | 5   | 4 | 3   | 2 | 1   |
|--------|-----|---|-----|---|-----|---|-----|
| in1[7] | ... |   | BI3 |   | BI2 |   | BI1 |

The following uses the first group of test excitation AI1, BI1, and CI1 as an example to describe how to check test excitation. The methods for checking other test excitation are similar.

As shown in FIG. 7, in a first clock cycle of a 1st test cycle, test excitation AI1 is input to input buses in1[0] to in1[3] of a core A. In order to fully occupy buses as much as possible, the first four bits of test excitation BI1 are input to input buses in1[4] to in1[7] of the core A. In the core A, a first DRU 301A coupled to the input buses in1[0] to in1[3] outputs the test excitation AI1 to a second DRU 302A coupled to the input buses in1[0] to in1[3] for storage. A first register 303A coupled to the input buses in1[4] to in1[7] outputs the first four bits of the test excitation BI1 to a second register 304A coupled to the input buses in1[0] to in1[3] for storage.

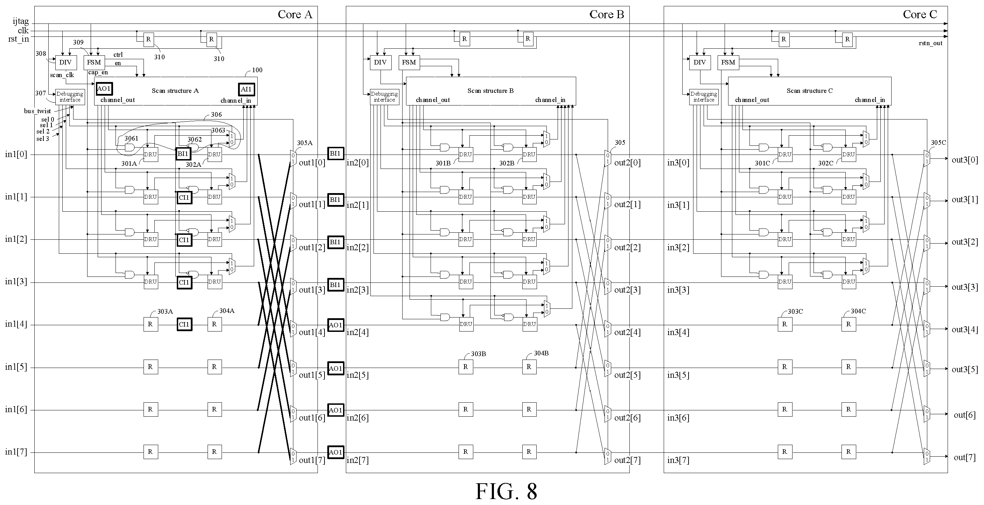

As shown in FIG. 8, in a second clock cycle of a 1st test cycle, a fifth bit of test excitation BI1 is input to an input bus in1[0] of a core A, and test excitation CI1 is input to input buses in1[1] to in1[4] of the core A. In the core A, a first selector 305A couples input buses in1[4] to in1[7] and output buses out1[0] to out1[3] respectively, and couples input buses in1[0] to in1[3] and output buses out1[4] to out1[7] respectively. A second DRU 302A coupled to the input buses in1[0] to in1[3] outputs the previously stored test excitation AI1 to an input channel channel_in of a scan structure A, and transmits the previous test response AO1 of the core A to a first DRU 301B of a core B coupled to input buses in2[4] to in2[7] and a first register 303B through the output buses out1[4] to out1[7] (that is, the input buses in2[4] to in2[7] of the core B) for storage. A second register 304A coupled to the input buses in1[4] to in1[7] transmits, through the output buses out1[0] to out1[3] (that is, input buses in2[0] to in2[3] of the core B), the first four bits of the previously stored test excitation BI1 to the first DRU 301B that is of the core B and that is coupled to the input buses in2[4] to in2[7] for storage. A first DRU 301 coupled to the input bus in1[0] transmits a fifth bit of the test excitation BI1 to a second DRU 302A coupled to the input bus in1[0] for storage. A first register 303A coupled to the input buses in1[1] to in1[4] transmits the test excitation CI1 to the second register 304A coupled to the input buses inl[1] to in1[4] for storage.

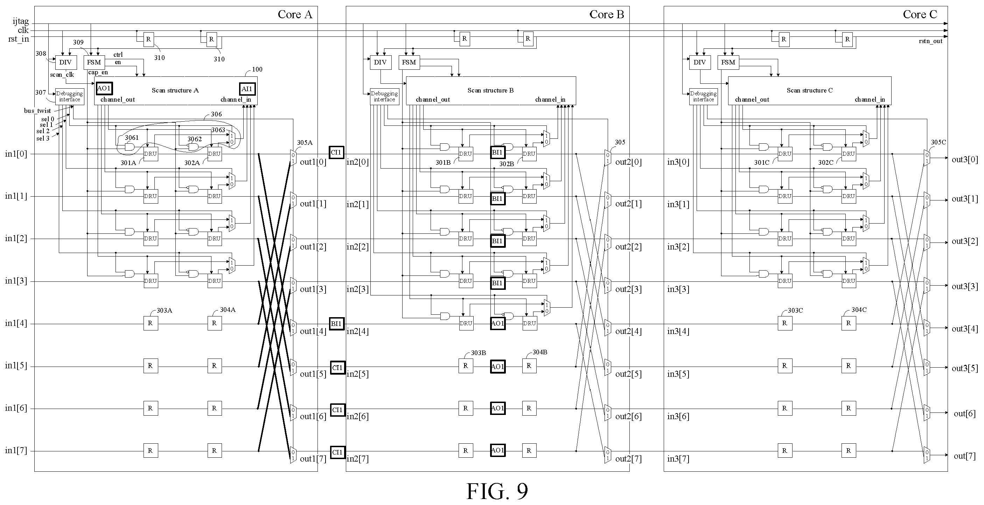

As shown in FIG. 9, in a first clock cycle of a 2nd test cycle, in a core B, a first DRU 301B coupled to input buses in2[0] to in2[3] outputs the first four bits of the previously stored test excitation BI1 to a second DRU 302B for storage, and a first register 303B coupled to input buses in2[4] to in2[7] outputs the previously stored test response AO1 to a second register 304B coupled to the input buses in2[4] to in2[7] for storage. In a core A, a second DRU 302A coupled to an input bus in1[0] transmits, through an output bus out1[4] (that is, an input bus in2[4] of the core B), the fifth bit of the previously stored test excitation BI1 to the first DRU 301B that is of the core B and that is coupled to the input bus in2[4] for storage. A second DRU 302A coupled to input buses inl[1] to in1[3] transmits, through output buses out1[5] to out11[7] (that is, input buses in2[5] to in2[7] of the core B), the first three bits of the previously stored test excitation CI1 to the first register 301B that is of the core B and that is coupled to the input buses in2[5] to in2[7] for storage. A second register 304A coupled to an input bus in1[4] transmits, through an output bus out1[0] (that is, an input bus in2[0] of the core B), the fourth bit of the previously stored test excitation CI1 to the first DRU 301B that is of the core B and that is coupled to the input bus in2[0] for storage.

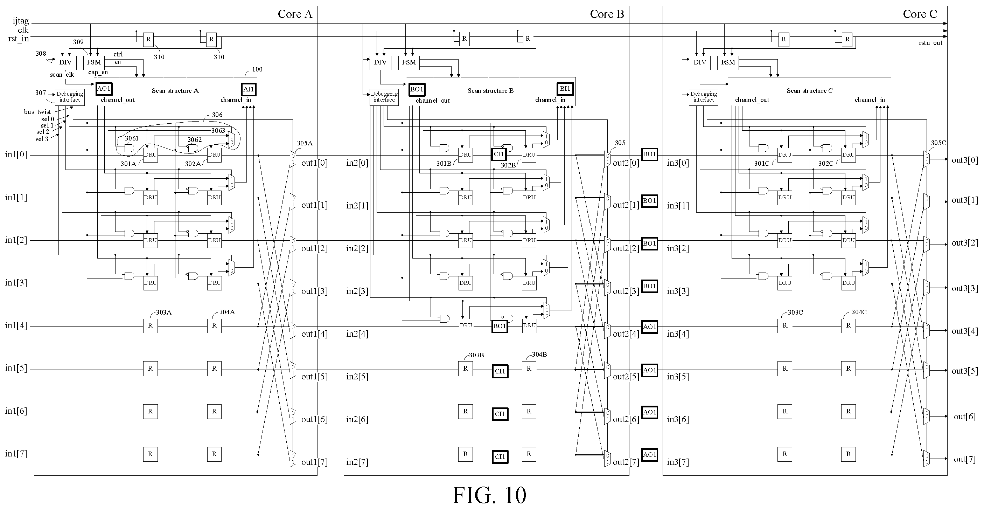

As shown in FIG. 10, in a second clock cycle of a 2nd test cycle, in a core B, a first selector 305B couples input buses in2[0] to in2[7] and output buses out2[0] to out2[7] respectively. A second DRU 302B coupled to input buses in2[0] to in2[3] outputs the first four bits of the previously stored test excitation BI1 to an input channel channel_in of a scan structure B, and transmits the first four bits of the previous test response BO1 of the core B to a first DRU 301C that is of a core C and that is coupled to input buses in3[0] to in3[3] through output buses out2[0] to out2[3] (that is, the input buses in3[0] to in3[3] of the core C) for storage. A first DRU 302B coupled to an input bus in2[4] outputs the fifth bit of the previously stored test excitation BI1 to the input channel channel_in of the scan structure B, and transmits the fifth bit of the previous test response BO1 of the core B to the second DRU 302B for storage. The second DRU 302B coupled to input buses in2[4] to in2[7] transmits the previously stored test response AO1 to a first register 303C that is of the core C and that is coupled to input buses in3[4] to in3[7] through output buses out2[4] to out2[7] (that is, the input buses in3[4] to in3[7] of the core C) for storage. A first register 303B coupled to input buses in2[5] to in2[7] transmits the first three bits of the previously stored test excitation CI1 to a second register 304B coupled to the input buses in2[5] to in2[7] for storage. A first DRU 301B coupled to an input bus in2[0] transmits the fourth bit of the previously stored test excitation CI1 to the second register 304B coupled to the input bus in2[0] for storage.

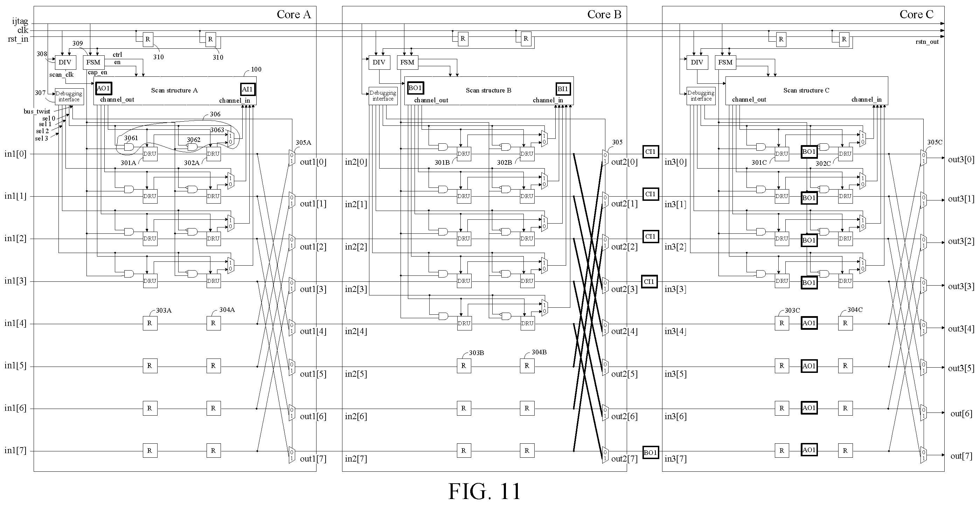

As shown in FIG. 11, in a first clock cycle of a 3rd test cycle, in a core C, a first DRU 301B coupled to input buses in3[0] to in3[3] outputs the first four bits of the previously stored test response BO1 to a second DRU 302C for storage. A first register 303C coupled to input buses in3[4] to in3[7] outputs the previously stored test response AO1 to a second register 304C coupled to the input buses in3[4] to in3[7] for storage. In a core B, a first selector 305B couples input buses in2[5] to in2[7] with output buses out2[0] to out2[2], and couples input buses in2[0] to in2[4] with output buses out2[3] to out2[7]. A second register 304B coupled to the input buses in2[5] to in2[7] transmits, through the output buses out2[0] to out2[2] (that is, input buses in3[0] to in3[2] of the core C), the first three bits of the previously stored test excitation CI1 to a first DRU 301C that is of the core C and is coupled to the input buses in3[0] to in3[2] for storage. A second DRU 302B coupled to an input bus in2[0] transmits, through an output bus out2[3] (that is, an input bus in3[3] of the core C), the fourth bit of the previously stored test excitation CI1 to the first DRU 301C that is of the core C and that is coupled to the input bus in3[3] for storage. The second DRU 302B coupled to an input bus in2[4] transmits, through an output bus out2[7] (that is, an input bus in3[7] of the core C), a fifth bit of the previously stored test response BO1 to the first register 303C that is of the core C and that is coupled to the input bus in3[7] for storage.

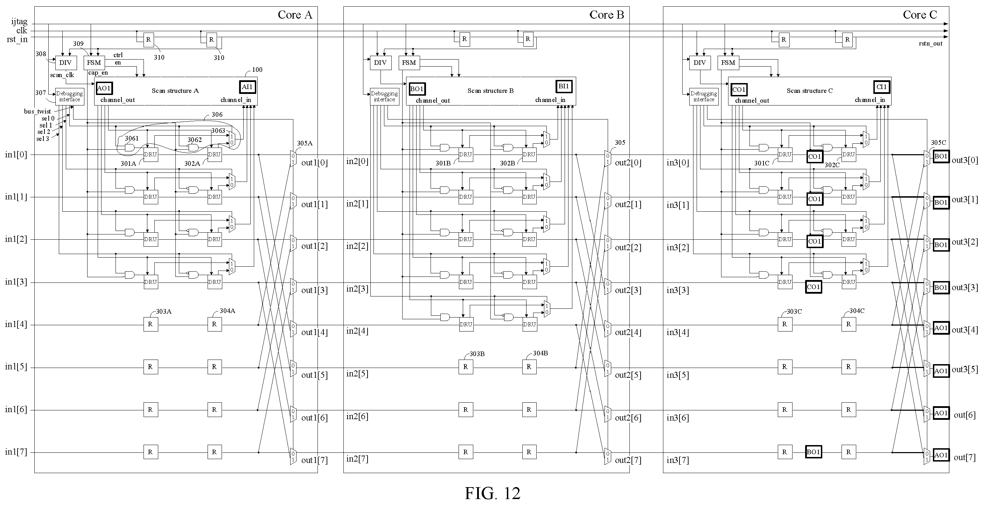

As shown in FIG. 12, in a second clock cycle of a 3rd test cycle, in a core C, a first selector 305C couples input buses in3[0] to in3[7] and output buses out3[0] to out3[7] respectively. A second DRU 302C coupled to input buses in3[0] to in3[3] outputs the first four bits of the previously stored test response BO1 through output buses out3[0] to out3[3]. A second register 304C coupled to input buses in3[4] to in3[7] outputs the previously stored test response AO1 through output buses out3[4] to out3[7]. A first register 303C coupled to an input bus in3[7] outputs the fifth bit of the previously stored test excitation BI1 to the second register 304C coupled to the input bus in3[7] for storage. A first DRU 301C coupled to the input buses in3[0] to in3[3] outputs the previously stored test excitation CI1 to an input channel channel_in of a scan structure C, and outputs the previous test response CO1 of the core C to the second DRU 302C coupled to the input buses in3[0] to in3[3] for storage.

In addition, in a next clock cycle, the second register 304C coupled to the input bus in3[7] outputs the previously stored fifth bit of the test excitation BI1 through the output bus out3[7]. The second DRU 302C coupled to the input buses in3[0] to in3[3] outputs the previously stored test response CO1 through the output buses out3[0] to out3[3].

Compared with other star structure solutions such as the SRF and the DBM, the test circuit provided in this embodiment of this application is more conducive to place and route, and does not have a problem of difficulty in winding. In addition, control logic is simple, an added circuit scale is small, and a test configuration is simpler. On the premise of reducing an area increase and physical design difficulty, bus resources are properly allocated to maximize utilization. A bottom-up design process is supported, and bus resource allocation is flexible and adjustable. A same hardware connection structure can implement a plurality of test solutions, making test plan flexible. Because only two clock cycles are required to complete data interaction with the tested circuit, transmission efficiency is improved. Data transmitted in each test bus can still be consistent in timing after passing through a plurality of cores. This improves the transmission rate of the bus.

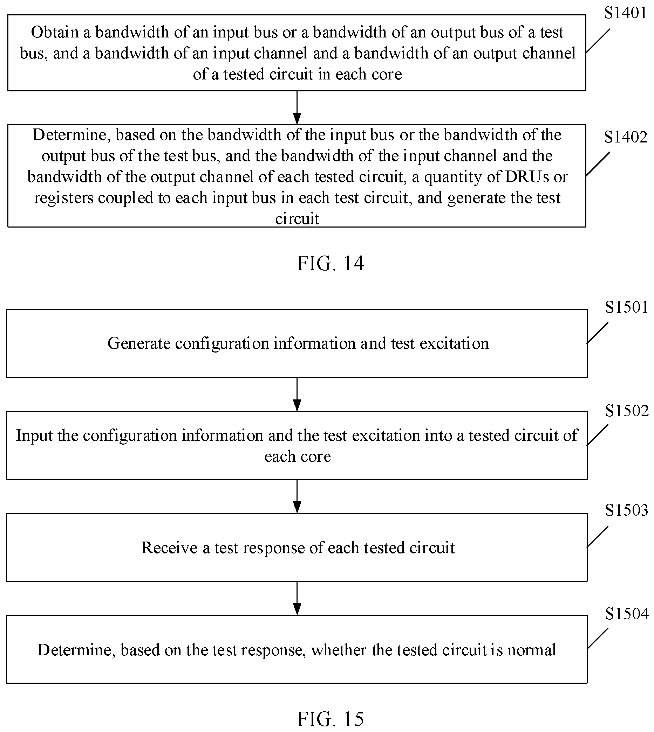

An embodiment of this application further provides a generation method for the foregoing test circuit, and the method may be executed by a processor in a computer. As shown in FIG. 14, the method includes the following steps.

S1401: Obtain a bandwidth of an input bus in or a bandwidth of an output bus out of a test bus, and a bandwidth of an input channel channel_in and a bandwidth of an output channel channel _out of a tested circuit in each core.

Data can be entered by a user or imported from a configuration. The bandwidth of the input bus in is generally equal to the bandwidth of the output bus out. A bandwidth of an input channel channel _in and a bandwidth of an output channel channel_out of a same tested circuit may be the same or different.

S1402: Determine, based on the bandwidth of the input bus or the bandwidth of the output bus of the test bus, and the bandwidth of the input channel and the bandwidth of the output channel of each tested circuit, a quantity of DRUs or registers coupled to each input bus in each test circuit, and generate the test circuit.

$$K = \lceil Max(CI,CO)/n \rceil$$

For example, a frequency division ratio K is calculated as follows: . CI represents a bandwidth of an input channel channel_in of a tested circuit in a core, CO represents a bandwidth of an output channel channel_out of a tested circuit in a core, and B represents the bandwidth of the input bus in or the bandwidth of the output bus out. The K value may be used as a quantity of DRUs or registers coupled to each input bus in each core, to generate a test circuit of a plurality of cores.

An embodiment of this application further provides a circuit test method, which may be executed by a processor in a computer, and is used to test a tested circuit by using the foregoing test circuit. As shown in FIG. 15, the method includes the following steps.

S1501: Generate configuration information and test excitation.

The configuration information is used to configure a frequency division ratio of a frequency divider 308, and the configuration information is further used to configure a selection signal of a debugging interface 307 in the foregoing test circuit, to select a first DRU 301 or a second DRU 302 to be coupled to an input channel channel_in of the tested circuit, to input the test excitation into the tested circuit through the first DRU 301 or the second DRU 302.

S1502: Input the configuration information and the test excitation into a tested circuit of each core.

The configuration information is used to be input to the tested circuit of each core through an ijtag bus of a test bus, and the test excitation is used to be input to the tested circuit of each core through an input bus in of the test bus.

S1503: Receive a test response of each tested circuit.

Specifically, the test response of each tested circuit is received through an output bus out in the test bus.

S1504: Determine, based on the test response, whether the tested circuit is normal.

If a test response output by a tested circuit does not meet an expected result, it may be determined that the tested circuit functions abnormally; otherwise, it is determined that the tested circuit functions normally.

An embodiment of this application further provides a computer-readable storage medium. The computer-readable storage medium includes instructions. When the instructions are executed by a processor, functions or steps in the foregoing method embodiments are performed. For example, the computer-readable storage medium may be a read-only memory (Read-Only Memory, ROM), a random access memory (Random Access Memory, RAM), a compact disc read-only memory (Compact Disc Read-Only Memory, CD-ROM), a tape, a floppy disk, an optical data storage device, or the like.

An embodiment of this application further provides a computer program product including instructions. When the instructions are executed by a processor, functions or steps in the foregoing method embodiments are performed.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device and method may be implemented in other manners. For example, the described device embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate components may or may not be physically separate, and components displayed as modules may or may not be physical modules, may be located in one device, or may be distributed on a plurality of devices. Some or all the modules may be selected according to actual needs to achieve the objectives of the solutions of embodiments.

In addition, functional modules in embodiments of this application may be integrated into one device, or each of the modules may exist alone physically, or two or more modules are integrated into one module.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid state disk, SSD)), or the like.

The foregoing descriptions are merely specific implementations of this application, but are not intended to limit the protection scope of this application. Therefore, the protection scope of this application shall be subject to the protection scope of the claims.

**Claims**

1. A test circuit, comprising: a first input bus, a second input bus, a first output bus, a second output bus, a first dynamic routing unit DRU, and a first register, wherein

   the first input bus is configured to be coupled to an input channel of a tested circuit through the first DRU, and the first output bus is configured to be coupled to an output channel of the tested circuit through the first DRU;
   the second input bus is configured to be coupled to the second output bus through the first register; and
   in a clock cycle: the first DRU is configured to output test excitation from the first input bus to the input channel, and output a test response from the output channel to the first output bus; or the first DRU is configured to output data from the first input bus to the first output bus; and the first register is configured to output data from the second input bus to the second output bus.

2. The test circuit according to claim 1, further comprising: a second DRU coupled to the first DRU, a selection circuit, and a second register coupled to the first register, wherein

   the first input bus is configured to be coupled to the input channel through the first DRU, the second DRU, and the selection circuit, and the first output bus is configured to be coupled to the output channel through the first DRU and the second DRU;
   the second input bus is configured to be coupled to the second output bus through the first register and the second register; and
   the selection circuit is configured to select the first DRU or the second DRU to be coupled to the input channel.

3. The test circuit according to claim 2, wherein

   in a first clock cycle, the first DRU is configured to output the test excitation to the second DRU; and in a second clock cycle, the selection circuit selects the second DRU to be coupled to the input channel, and the second DRU is configured to output the test excitation to the input channel, and output the test response to the first output bus; or
   in a second clock cycle, the selection circuit selects the first DRU to be coupled to the input channel, and the first DRU is configured to output the test excitation to the input channel, and output the test response to the first output bus.

4. The test circuit according to claim 2 or 3, wherein the selection circuit comprises a first AND gate, a second AND gate, and a second selector, wherein a first input of the second AND gate performs phase inversion on an input signal;

   an output of the first AND gate is coupled to the first DRU to output a first signal to the first DRU, an output of the second AND gate is coupled to the second DRU to output a second signal to the second DRU, a first input of the first AND gate and the first input of the second AND gate are coupled to a control end of the second selector and are configured to input a third signal, a second input of the first AND gate and a second input of the second AND gate are coupled and are configured to input a fourth signal, two inputs of the second selector are respectively coupled to the first DRU and the second DRU, and an output of the second selector is configured to be coupled to the input channel; and
   the first signal is used to control the first DRU whether to output the test excitation to the input channel, the second signal is used to control the second DRU whether to output the test excitation to the input channel, the third signal is used to control the selection circuit to select the first DRU or the second DRU to be coupled to the input channel, and the fourth signal is used to control the first DRU or the second DRU whether to output the test excitation to the input channel.

5. The test circuit according to any one of claims 1 to 4, wherein the first DRU comprises a third register and a third selector; and
   a data input of the third register is configured to be coupled to the first input bus, a data output of the third register is configured to be separately coupled to a second input of the third selector and the input channel, a first input of the third selector is configured to be coupled to the output channel, an output of the third selector is configured to be coupled to the first output bus, a control end of the third selector is configured to input a fifth signal, and the fifth signal is used to control the third selector to connect the first input or the second input to the output.

6. The test circuit according to any one of claims 1 to 5, further comprising: a reset input bus, a reset output bus, and a plurality of fourth registers, wherein a quantity of the fourth registers is equal to a quantity of registers coupled to the second input bus; the reset input bus is coupled to the reset output bus through the plurality of fourth registers; the reset input bus is configured to input a reset signal; and the reset output bus is configured to output, to the test circuit, the reset signal delayed by the plurality of fourth registers.

7. The test circuit according to any one of claims 1 to 6, further comprising a plurality of fifth registers, wherein the first input bus and the second input bus each are coupled to A fifth registers, and A is a positive integer.

8. The test circuit according to any one of claims 1 to 7, further comprising a plurality of sixth registers, wherein the first output bus and the second output bus each are coupled to B sixth registers, and B is a positive integer.

9. An integrated circuit, comprising a plurality of cores, wherein each core comprises a tested circuit and the test circuit according to any one of claims 1 to 8, and test circuits of the plurality of cores are coupled through a test bus.

10. An electronic device, comprising a printed circuit board and the integrated circuit according to claim 9 disposed on the printed circuit board.

11. A method for generating a test circuit, comprising:

   obtaining a bandwidth of an input bus or a bandwidth of an output bus of a test bus, and a bandwidth of an input channel and a bandwidth of an output channel of a tested circuit in each core; and
   determining, based on the bandwidth of the input bus or the bandwidth of the output bus of the test bus, and the bandwidth of the input channel and the bandwidth of the output channel of the tested circuit in each core, a quantity of dynamic routing units DRUs or registers coupled to each input bus in each test circuit, and generating the test circuit according to any one of claims 1 to 8.

12. The method according to claim 11, wherein a quantity K of dynamic routing units or registers coupled to each input bus

$$K = \lceil Max(CI, CO)/n \rceil$$

in a test circuit in each core is obtained in the following manner: , wherein $CI$ represents a bandwidth of an input channel of a tested circuit in a core, CO represents a bandwidth of an output channel of the tested circuit in the core, and n represents the bandwidth of the input bus or the bandwidth of the output bus.

13. A circuit test method, used to test a tested circuit by using the test circuit according to any one of claims 1 to 8, wherein the method comprises:

   generating configuration information and test excitation, wherein the configuration information is used to configure a frequency division ratio of the test circuit, and the test excitation is used to be input to the tested circuit;
   inputting the configuration information and the test excitation into the tested circuit;
   receiving a test response of the tested circuit; and
   determining, based on the test response, whether the tested circuit is normal.


**Patentansprüche**

1. Testschaltung, umfassend: einen ersten Eingangsbus, einen zweiten Eingangsbus, einen ersten Ausgangsbus, einen zweiten Ausgangsbus, eine erste dynamische Routing-Einheit, DRU, und ein erstes Register, wobei

   der erste Eingangsbus dazu konfiguriert ist, über die erste DRU an einen Eingangskanal einer getesteten Schaltung gekoppelt zu sein, und der erste Ausgangsbus dazu konfiguriert ist, über die erste DRU an einen Ausgangskanal der getesteten Schaltung gekoppelt zu sein;
   der zweite Eingangsbus dazu konfiguriert ist, über das erste Register an den zweiten Ausgangsbus gekoppelt zu sein; und
   in einem Taktzyklus: die erste DRU dazu konfiguriert ist, eine Testanregung von dem ersten Eingangsbus an den Eingangskanal auszugeben und eine Testantwort von dem Ausgangskanal an den ersten Ausgangsbus auszugeben; oder die erste DRU dazu konfiguriert ist, Daten von dem ersten Eingangsbus an den ersten Ausgangsbus auszugeben; und das erste Register dazu konfiguriert ist, Daten von dem zweiten Eingangsbus an den zweiten Ausgangsbus auszugeben.

2. Testschaltung nach Anspruch 1, ferner Folgendes umfassend:

eine zweite DRU, die an die erste DRU, eine Auswahlschaltung und ein zweites Register gekoppelt ist, das an das erste Register gekoppelt ist, wobei der erste Eingangsbus dazu konfiguriert ist, über die erste DRU, die zweite DRU und die Auswahlschaltung an den Eingangskanal gekoppelt zu sein, und der erste Ausgangsbus dazu konfiguriert ist, über die erste DRU und die zweite DRU an den Ausgangskanal gekoppelt zu sein; der zweite Eingangsbus dazu konfiguriert ist, über das erste Register und das zweite Register an den zweiten Ausgangsbus gekoppelt zu sein; und die Auswahlschaltung dazu konfiguriert ist, die erste DRU oder die zweite DRU auszuwählen, um an den Eingangskanal gekoppelt zu sein.

3. Testschaltung nach Anspruch 2, wobei

in einem ersten Taktzyklus, die erste DRU dazu konfiguriert ist, die Testanregung an die zweite DRU auszugeben; und, in einem zweiten Taktzyklus, die Auswahlschaltung die zweite DRU auswählt, um an den Eingangskanal gekoppelt zu sein, und die zweite DRU dazu konfiguriert ist, die Testanregung an den Eingangskanal auszugeben und die Testantwort an den ersten Ausgangsbus auszugeben; oder in einem zweiten Taktzyklus, die Auswahlschaltung die erste DRU auswählt, um an den Eingangskanal gekoppelt zu sein, und die erste DRU dazu konfiguriert ist, die Testanregung an den Eingangskanal auszugeben und die Testantwort an den ersten Ausgangsbus auszugeben.

4. Testschaltung nach Anspruch 2 oder 3, wobei die Auswahlschaltung ein erstes UND-Gatter, ein zweites UND-Gatter und einen zweiten Selektor umfasst, wobei ein erster Eingang des zweiten UND-Gatters eine Phasenumkehr an einem Eingangssignal durchführt;

ein Ausgang des ersten UND-Gatters an die erste DRU gekoppelt ist, um ein erstes Signal an die erste DRU auszugeben, ein Ausgang des zweiten UND-Gatters an die zweite DRU gekoppelt ist, um ein zweites Signal an die zweite DRU auszugeben, ein erster Eingang des ersten UND-Gatters und der erste Eingang des zweiten UND-Gatters an ein Steuerende des zweiten Selektors gekoppelt sind und dazu konfiguriert sind, ein drittes Signal einzugeben, ein zweiter Eingang des ersten UND-Gatters und ein zweiter Eingang des zweiten UND-Gatters gekoppelt sind und dazu konfiguriert sind, ein viertes Signal einzugeben, zwei Eingänge des zweiten Selektors jeweils an die erste DRU und die zweite DRU gekoppelt sind und ein Ausgang des zweiten Selektors dazu konfiguriert ist, an den Eingangskanal gekoppelt zu sein; und das erste Signal dazu verwendet wird, die erste DRU zu steuern, ob sie die Testanregung an den Eingangskanal ausgibt, das zweite Signal dazu verwendet wird, die zweite DRU zu steuern, ob sie die Testanregung an den Eingangskanal ausgibt, das dritte Signal dazu verwendet wird, die Auswahlschaltung zu steuern, um die erste DRU oder die zweite DRU auszuwählen, die mit dem Eingangskanal zu koppeln ist, und das vierte Signal dazu verwendet wird, die erste DRU oder die zweite DRU zu steuern, ob sie die Testanregung an den Eingangskanal ausgibt.

5. Testschaltung nach einem der Ansprüche 1 bis 4, wobei die erste DRU ein drittes Register und einen dritten Selektor umfasst; und ein Dateneingang des dritten Registers dazu konfiguriert ist, an den ersten Eingangsbus gekoppelt zu sein, ein Datenausgang des dritten Registers dazu konfiguriert ist, separat an einen zweiten Eingang des dritten Selektors und den Eingangskanal gekoppelt zu sein, ein erster Eingang des dritten Selektors dazu konfiguriert ist, an den Ausgangskanal gekoppelt zu sein, ein Ausgang des dritten Selektors dazu konfiguriert ist, an den ersten Ausgangsbus gekoppelt zu sein, ein Steuerende des dritten Selektors dazu konfiguriert ist, ein fünftes Signal einzugeben, und das fünfte Signal dazu verwendet wird, den dritten Selektor zu steuern, um den ersten Eingang oder den zweiten Eingang mit dem Ausgang zu verbinden.

6. Testschaltung nach einem der Ansprüche 1 bis 5, ferner Folgendes umfassend: einen Zurücksetzungseingangsbus, einen Zurücksetzungsausgangsbus und eine Vielzahl von vierten Registern, wobei eine Anzahl der vierten Register gleich einer Anzahl von Registern, die an den zweiten Eingangsbus gekoppelt sind, ist; der Zurücksetzungseingangsbus über die Vielzahl von vierten Registern an den Zurücksetzungsausgangsbus gekoppelt ist; der Zurücksetzungseingangsbus dazu konfiguriert ist, ein Zurücksetzungssignal einzugeben; und der Zurücksetzungsausgangsbus dazu konfiguriert ist, das Zurücksetzungssignal, das durch die Vielzahl von vierten Registern verzögert wird, an die Testschaltung auszugeben.

**7.** Testschaltung nach einem der Ansprüche 1 bis 6, ferner umfassend eine Vielzahl von fünften Registern, wobei der erste Eingangsbus und der zweite Eingangsbus jeder an A fünfte Register gekoppelt sind und A eine positive ganze Zahl ist.

**8.** Testschaltung nach einem der Ansprüche 1 bis 7, ferner umfassend eine Vielzahl von sechsten Registern, wobei der erste Ausgangsbus und der zweite Ausgangsbus jeder an B sechste Register gekoppelt sind und B eine positive ganze Zahl ist.

**9.** Integrierte Schaltung, umfassend eine Vielzahl von Kernen, wobei jeder Kern eine getestete Schaltung und die Testschaltung nach einem der Ansprüche 1 bis 8 umfasst und die Testschaltungen der Vielzahl von Kernen über einen Testbus gekoppelt sind.

**10.** Elektronische Vorrichtung, die eine Leiterplatte und die integrierte Schaltung nach Anspruch 9, die auf der Leiterplatte angeordnet ist, umfasst.

**11.** Verfahren zum Erzeugen einer Testschaltung, umfassend:
Erlangen einer Bandbreite eines Eingangsbusses oder einer Bandbreite eines Ausgangsbusses eines Testbusses und einer Bandbreite eines Eingangskanals und einer Bandbreite eines Ausgangskanals einer getesteten Schaltung in jedem Kern; und Bestimmen, basierend auf der Bandbreite des Eingangsbusses oder der Bandbreite des Ausgangsbusses des Testbusses und der Bandbreite des Eingangskanals und der Bandbreite des Ausgangskanals der getesteten Schaltung in jedem Kern, einer Anzahl dynamischer Routing-Einheiten, DRUs, oder Register, die an jeden Eingangsbus in jeder Testschaltung gekoppelt sind, und Erzeugen der Testschaltung nach einem der Ansprüche 1 bis 8.

**12.** Verfahren nach Anspruch 11, wobei eine Anzahl K von dynamischen Routing-Einheiten oder Registern, die an jeden Eingangsbus in einer Testschaltung in jedem Kern gekoppelt sind, auf die folgende Weise erlangt wird:

$$K=\lceil Max(CI,CO)/n \rceil$$

, wobei $CI$ eine Bandbreite eines Eingangskanals einer getesteten Schaltung in einem Kern darstellt, CO eine Bandbreite eines Ausgangskanals der getesteten Schaltung in dem Kern darstellt und n die Bandbreite des Eingangsbusses oder die Bandbreite des Ausgangsbusses darstellt.

**13.** Schaltungstestverfahren, das dazu verwendet wird, eine getestete Schaltung unter Verwendung der Testschaltung nach einem der Ansprüche 1 bis 8 zu testen, wobei das Verfahren Folgendes umfasst:

Erzeugen von Konfigurationsinformationen und Testanregung, wobei die Konfigurationsinformationen dazu verwendet werden, ein Frequenzteilungsverhältnis der Testschaltung zu konfigurieren, und die Testanregung dazu verwendet wird, in die getestete Schaltung eingegeben zu werden;
Eingeben der Konfigurationsinformationen und der Testanregung in die getestete Schaltung;
Empfangen einer Testantwort der getesteten Schaltung; und
Bestimmen, basierend auf der Testantwort, ob die getestete Schaltung normal ist.

**Revendications**

**1.** Circuit d'essai, comprenant : un premier bus d'entrée, un second bus d'entrée, un premier bus de sortie, un second bus de sortie, une première unité de routage dynamique (DRU) et un premier registre, dans lequel

le premier bus d'entrée est configuré pour être couplé à un canal d'entrée d'un circuit essayé via la première DRU, et le premier bus de sortie est configuré pour être couplé à un canal de sortie du circuit essayé via la première DRU ;
le second bus d'entrée est configuré pour être couplé au second bus de sortie via le premier registre ; et
dans un cycle d'horloge : la première DRU est configurée pour envoyer une excitation d'essai du premier bus d'entrée au canal d'entrée, et envoyer une réponse d'essai du canal de sortie vers le premier bus de sortie ; ou la première DRU est configurée pour envoyer des données du premier bus d'entrée vers le premier bus de sortie ; et le premier registre est configuré pour envoyer des données du second bus d'entrée vers le second bus de sortie.

**2.** Circuit d'essai selon la revendication 1, comprenant également : une seconde DRU couplée à la première DRU, un circuit de sélection, et un deuxième registre couplé au premier registre, dans lequel

le premier bus d'entrée est configuré pour être couplé au canal d'entrée via la première DRU, la seconde DRU, et le circuit de sélection, et le premier bus de sortie est configuré pour être couplé au canal de sortie via la première DRU et la seconde DRU ;
le second bus d'entrée est configuré pour être couplé au second bus de sortie via le premier registre et le deuxième registre ; et
le circuit de sélection est configuré pour sélectionner la première DRU ou la seconde DRU à coupler au canal d'entrée.

3. Circuit d'essai selon la revendication 2, dans lequel

dans un premier cycle d'horloge, la première DRU est configurée pour envoyer l'excitation d'essai vers la seconde DRU ; et dans un second cycle d'horloge, le circuit de sélection sélectionne la seconde DRU à coupler au canal d'entrée, et la seconde DRU est configurée pour envoyer l'excitation d'essai vers le canal d'entrée, et envoyer la réponse d'essai vers le premier bus de sortie ; ou
dans un second cycle d'horloge, le circuit de sélection sélectionne la première DRU à coupler au canal d'entrée, et la première DRU est configurée pour envoyer l'excitation d'essai vers le canal d'entrée, et envoyer la réponse d'essai vers le premier bus de sortie.

4. Circuit d'essai selon la revendication 2 ou 3, dans lequel le circuit de sélection comprend une première porte AND, une seconde porte AND, et un deuxième sélecteur, dans lequel une première entrée de la seconde porte AND effectue une inversion de phase sur un signal d'entrée ;

une sortie de la première porte AND est couplée à la première DRU pour envoyer un premier signal vers la première DRU, une sortie de la seconde porte AND est couplée à la seconde DRU pour envoyer un deuxième signal vers la seconde DRU, une première entrée de la première porte AND et la première entrée de la seconde porte AND sont couplées à une extrémité de commande du deuxième sélecteur et sont configurées pour entrer un troisième signal, une seconde entrée de la première porte AND et une seconde entrée de la seconde porte AND sont couplées et sont configurées pour entrer un quatrième signal, deux entrées du deuxième sélecteur sont respectivement couplées à la première DRU et à la seconde DRU, et une sortie du deuxième sélecteur est configurée pour être couplée au canal d'entrée ; et
le premier signal est utilisé pour commander à la première DRU si elle doit envoyer l'excitation d'essai au canal d'entrée, le deuxième signal est utilisé pour commander à la seconde DRU si elle doit envoyer l'excitation d'essai au canal d'entrée, le troisième signal est utilisé pour commander au circuit de sélection de sélectionner la première DRU ou la seconde DRU à coupler au canal d'entrée, et le quatrième signal est utilisé pour commander à la première DRU ou à la seconde DRU si elle doit envoyer l'excitation d'essai au canal d'entrée.

5. Circuit d'essai selon l'une quelconque des revendications 1 à 4, dans lequel la première DRU comprend un troisième registre et un troisième sélecteur ; et
une entrée de données du troisième registre est configurée pour être couplée au premier bus d'entrée, une sortie de données du troisième registre est configurée pour être couplée séparément à une seconde entrée du troisième sélecteur et au canal d'entrée, une première entrée du troisième sélecteur est configurée pour être couplée au canal de sortie, une sortie du troisième sélecteur est configurée pour être couplée au premier bus de sortie, une extrémité de commande du troisième sélecteur est configurée pour entrer un cinquième signal, et le cinquième signal est utilisé pour commander au troisième sélecteur de connecter la première entrée ou la seconde entrée à la sortie.

6. Circuit d'essai selon l'une quelconque des revendications 1 à 5, comprenant également : un bus d'entrée de réinitialisation, un bus de sortie de réinitialisation, et une pluralité de quatrièmes registres, dans lequel le nombre de quatrièmes registres est égal au nombre de registres couplés au second bus d'entrée ; le bus d'entrée de réinitialisation est couplé au bus de sortie de réinitialisation via la pluralité de quatrièmes registres ; le bus d'entrée de réinitialisation est configuré pour entrer un signal de réinitialisation ; et le bus de sortie de réinitialisation est configuré pour envoyer au circuit d'essai le signal de réinitialisation retardé par la pluralité de quatrièmes registres.

7. Circuit d'essai selon l'une quelconque des revendications 1 à 6, comprenant également une pluralité de cinquièmes registres, dans lequel le premier bus d'entrée et le second bus d'entrée sont chacun couplés à A cinquièmes registres, et A est un entier positif.

8. Circuit d'essai selon l'une quelconque des revendications 1 à 7, comprenant également une pluralité de sixièmes registres, dans lequel le premier bus d'entrée et le second bus d'entrée sont chacun couplés à B sixièmes registres, et B est un entier positif.

9. Circuit intégré, comprenant une pluralité de cœurs, dans lequel chaque cœur comprend un circuit essayé et le circuit d'essai selon l'une quelconque des revendications 1 à 8, et les circuits d'essai de la pluralité de cœurs sont couplés via un bus d'essai.

10. Dispositif électronique, comprenant une carte de circuit imprimé et le circuit intégré selon la revendication 9 disposé sur la carte de circuit imprimé.

11. Procédé de génération d'un circuit d'essai, comprenant :
l'obtention d'une bande passante d'un bus d'entrée ou d'une bande passante d'un bus de sortie d'un bus d'essai, et d'une bande passante d'un canal d'entrée et d'une bande passante d'un canal de sortie d'un circuit essayé dans chaque cœur ; et la détermination, sur la base de la bande passante du bus d'entrée ou de la bande passante du bus de sortie du bus d'essai, et de la bande passante du canal d'entrée et de la bande passante du canal de sortie du circuit essayé dans chaque cœur, d'un nombre d'unités de routage dynamiques DRU ou de registres couplés à chaque bus d'entrée dans chaque circuit d'essai, et la génération du circuit d'essai selon l'une quelconque des revendications 1 à 8.

12. Procédé selon la revendication 11, dans lequel un nombre K d'unités de routage dynamiques ou de registres couplés à chaque bus d'entrée dans un circuit d'essai dans chaque cœur est obtenue de la manière suivante :

$$K = \lceil Max(CI, CO)/n \rceil$$

, dans lequel $CI$ représente une bande passante d'un canal d'entrée d'un circuit essayé dans un cœur, CO représente une bande passante d'un canal de sortie du circuit essayé dans le cœur, et n représente la bande passante du bus d'entrée ou la bande passante du bus de sortie.

13. Procédé d'essai de circuit, utilisé pour essayer un circuit essayé en utilisant le circuit d'essai selon l'une quelconque des revendications 1 à 8, dans lequel le procédé comprend :

la génération d'informations de configuration et d'excitation d'essai, dans lequel les informations de configuration sont utilisées pour configurer un rapport de division de fréquence du circuit d'essai, et l'excitation d'essai est utilisée pour être entrée dans le circuit essayé ;
la saisie des informations de configuration et de l'excitation d'essai dans le circuit essayé ;
la réception d'une réponse d'essai du circuit essayé ; et
le fait de déterminer, sur la base de la réponse d'essai, si le circuit essayé est normal.

FIG. 1

FIG. 2

FIG. 3

FIG. 4

channel_out    channel_in

cap_en

402

in

R

1

0

out

DRU

401

FIG. 5

FIG. 6

FIG. 7

EP 4 386 396 B1

FIG. 8

EP 4 386 396 B1

FIG. 9

FIG. 10

FIG. 11

FIG. 12

FIG. 13

EP 4 386 396 B1

Obtain a bandwidth of an input bus or a bandwidth of an output bus of a test bus, and a bandwidth of an input channel and a bandwidth of an output channel of a tested circuit in each core

S1401

Determine, based on the bandwidth of the input bus or the bandwidth of the output bus of the test bus, and the bandwidth of the input channel and the bandwidth of the output channel of each tested circuit, a quantity of DRUs or registers coupled to each input bus in each test circuit, and generate the test circuit

S1402

FIG. 14

Generate configuration information and test excitation

S1501

Input the configuration information and the test excitation into a tested circuit of each core

S1502

Receive a test response of each tested circuit

S1503

Determine, based on the test response, whether the tested circuit is normal

S1504

FIG. 15

**EP 4 386 396 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 107345997